# EUROPEAN PATENT APPLICATION

(11) **EP 4 712 079 A1**
(43) Date of publication of application: **18.03.2026**
(21) Application number: 25191925.4
(22) Date of filing: 25.07.2025
(51) Int. Cl.: G11C 16/10, G11C 16/24, G11C 16/32, G11C 11/56, G11C 16/08, G11C 16/26, G11C 16/34, G11C 16/04

(54) **SEMICONDUCTOR MEMORY DEVICE**

(30) Priority: 11.09.2024 JP 2024157319
(71) Applicant: Kioxia Corporation, Tokyo 105-0023 (JP)
(72) Inventor: Inuzuka, Yuki, Tokyo, 105-0023 (JP)
(74) Representative: Marks & Clerk LLP

(57) **Abstract**

A non-volatile semiconductor memory device includes a first semiconductor layer including a first memory cell transistor including a first channel, a second semiconductor layer including a second memory cell transistor including a second channel, a third semiconductor layer including a third memory cell transistor including a third channel, and a control circuit that controls the first memory cell transistor to the third memory cell transistor so that a write operation can be performed. When performing a write operation on the second memory cell transistor, the control circuit supplies a first voltage that is a reference voltage to the second channel, supplies a second voltage that is greater than the first voltage to the first channel, and then supplies the second voltage to the third channel, thereby boosting the voltage supplied to the first channel to a third voltage that is greater than the second voltage.

## Description

### FIELD

Embodiments described herein relate generally to a non-volatile semiconductor memory device.

### BACKGROUND

A NAND flash memory is known as a non-volatile semiconductor memory device. To increase the capacity of NAND flash memory, three-dimensional NAND flash memory, in which multiple cells are arranged three-dimensionally, has been put to practical use. For example, embodiments of the three-dimensional NAND flash memory can be categorized into a form in which memory strings are formed vertically and a form in which memory strings are formed horizontally.

### BRIEF DESCRIPTION OF THE DRAWINGS

FIG. 1 is a block diagram of a non-volatile semiconductor memory device according to an embodiment.
FIG. 2 is a circuit diagram of a memory cell array included in a non-volatile semiconductor memory device according to an embodiment.
FIG. 3 is a plan view showing a configuration of a memory cell region, a part of an SGD region, and a part of an SGS region of a non-volatile semiconductor memory device according to an embodiment.
FIG. 4 is a plan view showing a planar configuration of a part of a memory cell region and an SGS region of a non-volatile memory device according to an embodiment.
FIG. 5 is a circuit diagram showing an example of a circuit configuration of a sense amplifier part according to an embodiment.
FIG. 6 is a threshold distribution diagram showing an example of a threshold distribution of a memory cell transistor according to an embodiment.
FIG. 7 is a diagram showing an example of a program loop in a non-volatile semiconductor memory device according to an embodiment.
FIG. 8 is a timing chart showing an example of a write operation in a non-volatile semiconductor memory device according to a comparative example.
FIG. 9 is a perspective view showing an example of a channel in a non-volatile semiconductor memory device according to an embodiment.
FIG. 10 is a perspective view showing an example of a state of a channel in the non-volatile semiconductor memory device according to the comparative example.
FIG. 11 is a perspective view showing an example of a channel in the non-volatile semiconductor memory device according to the comparative example.
FIG. 12 is a timing chart showing a write operation in a non-volatile semiconductor memory device according to an embodiment.
FIG. 13 is a threshold distribution diagram showing an example of a threshold distribution of a memory cell transistor according to an embodiment.
FIG. 14 is a timing chart showing a write operation in a non-volatile semiconductor memory device according to an embodiment.
FIG. 15 is a timing chart showing a write operation in a non-volatile semiconductor memory device according to an embodiment.

### DETAILED DESCRIPTION

An object of the present disclosure is to provide a non-volatile semiconductor memory device capable of suppressing deterioration in the distribution width of a threshold value.

A non-volatile semiconductor memory device according to this embodiment includes a plurality of first memory cell transistors, a plurality of second memory cell transistors, and a plurality of third memory cell transistors, each of which can be set to a threshold voltage of 2ⁿ (n is an integer equal to or greater than 2) or more different levels, a first bit line extending in a first direction, a second bit line and a third bit line parallel to the first bit line, a source line arranged on a side opposite to the first bit line with respect to the first direction and extending along a second direction intersecting the first direction, a first semiconductor layer extending in the first direction and including the plurality of first memory cell transistors electrically connected between the first bit line and the source line, a second semiconductor layer including the plurality of second memory cell transistors connected between the second bit line and the source line and stacked with the first semiconductor layer along a third direction intersecting both the first direction and the second direction, a third semiconductor layer including the plurality of third memory cell transistors connected between the third bit line and the source line and stacked on a side of the first semiconductor layer opposite to a side on which the second semiconductor layer is stacked along the third direction, and a control circuit configured to control each of the plurality of the first memory cell transistors, each of the plurality of the second memory cell transistors, and each of the plurality of the third memory cell transistors to execute a write operation including a first operation and a second operation, wherein when performing the write operation for writing data to one second memory cell transistor among the plurality of the second memory cell transistors, the control circuit performs control so that it possible to perform the first operation of supplying a first voltage as a reference voltage to the second bit line and a second channel of the plurality of the second memory cell transistors, supplying a second voltage greater than the first voltage to the first bit line and a first channel of the plurality of the first memory cell transistors, and then supplying the second voltage to the third bit line and a third channel of the plurality of the third memory cell transistors, and boosting the voltage supplied to the first channel to a third voltage greater than the second voltage.

Hereinafter, a non-volatile semiconductor memory device according to an embodiment will be described with reference to the drawings. Further, in the following description, components having the same functions and configurations are denoted by common reference signs. In addition, in the case where a plurality of constituent elements having common reference signs are distinguished from each other, the same reference signs are attached with subscripts to distinguish the constituent elements. In addition, in the case where a plurality of components need not be distinguished from each other, only a common reference sign is attached to the plurality of constituent elements, and a subscript is not attached thereto.

In the specification, drawings, and claims of the present application (hereinafter, also referred to as "the present specification and the like"), a non-volatile semiconductor memory device which is one of the embodiments is, for example, a three-dimensional NAND type flash memory, and more specifically, a three-dimensional NAND type flash memory in which a memory string extends horizontally.

### [First Embodiment]

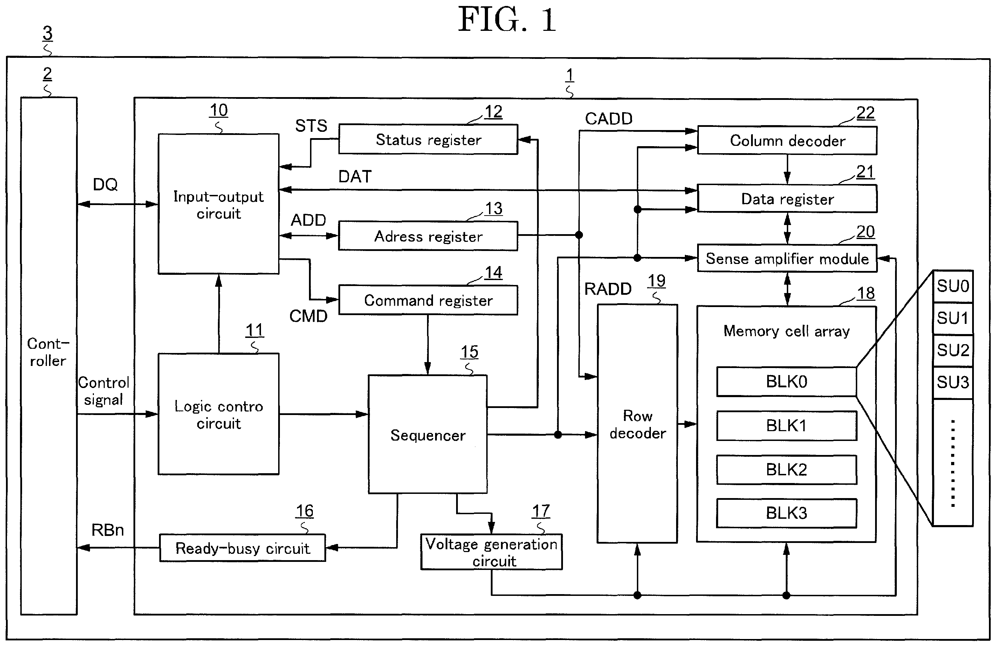

Referring to FIG. 1 to FIG. 13, a non-volatile semiconductor memory device 1 and a method for driving the non-volatile semiconductor memory device 1 will be described.

### [1. Memory System Configuration]

A configuration of a memory system will be described with reference to FIG. 1. FIG. 1 is a block diagram showing an example of a configuration of a memory system 3 including a non-volatile semiconductor memory device 1. As shown in FIG. 1, the memory system 3 includes the non-volatile semiconductor memory device 1 and a memory controller 2. For example, the memory system 3 is a memory card such as an SSD (solid state drive) or an SDTM card. The memory system 3 may include a host device (not shown). For example, the memory controller 2 controls a write operation, a read operation, and an erase operation of the non-volatile semiconductor memory device 1.

### [2. Configuration of Non-volatile Semiconductor Memory Device]

A configuration of the non-volatile semiconductor memory device 1 will be described with reference to FIG. 1. The non-volatile semiconductor memory device 1 includes an input-output circuit 10, a logic control circuit 11, a status register 12, an address register 13, a command register 14, a sequencer 15, a ready-busy circuit 16, a voltage generation circuit 17, a memory cell array 18, a row decoder 19, a sense amplifier module 20, a data register 21, and a column decoder 22.

The input-output circuit 10 controls inputting (receiving) a signal DQ from the memory controller 2 and outputting (transmitting) the signal DQ to the memory controller 2. For example, the signal DQ includes data DAT, an address ADD, and a command CMD. More specifically, the input-output circuit 10 transmits the data DAT received from the memory controller 2 to the data register 21, transmits the address ADD received from the memory controller 2 to the address register 13, and transmits the command CMD received from the memory controller 2 to the command register 14. Further, the input-output circuit 10 transmits status information STS received from the status register 12, the data DAT received from the data register 21, the address ADD received from the address register 13, and the like to the memory controller 2.

The logic control circuit 11 receives various types of control signals from the memory controller 2. The logic control circuit 11 controls the input-output circuit 10 and the sequencer 15 according to the received control signal.

For example, the status register 12 temporarily holds the status data STS in the write operation, the read operation, and the erase operation, and notifies the memory controller 2 of whether or not the operations have been normally completed.

The address register 13 temporarily holds the received address ADD. The address register 13 transfers a row address RADD to the row decoder 19, and transfers the column address CADD to the column decoder 22.

The command register 14 temporarily stores the received command CMD and transfers the command CMD to the sequencer 15.

The sequencer 15 controls the operation of the non-volatile semiconductor memory device 1. For example, the sequencer 15 controls the status register 12, the ready-busy circuit 16, the voltage generation circuit 17, the row decoder 19, the sense amplifier module 20, the data register 21, the column decoder 22, and the like in accordance with the received command CMD, and executes the write operation, the read operation, the erase operation, and the like. The sequencer 15 in the non-volatile semiconductor memory device 1 may be referred to as a "controller".

The ready-busy circuit 16 transmits a ready-busy signal RBn to the memory controller 2 in accordance with an operation status of the sequencer 15.

The voltage generation circuit 17 generates voltages necessary for the write operation, the read operation, and the erase operation under the control of the sequencer 15. For example, the voltage generation circuit 17 supplies the generated voltage to the memory cell array 18, the row decoder 19, the sense amplifier module 20, and the like. The row decoder 19 and the sense amplifier module 20 apply the voltage supplied from the voltage generation circuit 17 to memory cell transistors in the memory cell array 18.

The memory cell array 18 includes a plurality of blocks BLK (BLK0 to BLK3, ...) including a plurality of non-volatile memory cell transistors MC associated with rows and columns. Each block BLK includes a plurality of string parts SU (SU0 to SU3, ...). Each string part SU includes a plurality of memory groups MG (memory string pairs). The number of blocks BLK in the memory cell array 18, the number of string parts SU in the blocks BLK, and the number of memory groups MG in the string parts SU are arbitrarily set. Details of the memory cell array 18 will be described later.

The row decoder 19 decodes the row address RADD. The row decoder 19 applies a necessary voltage to the memory cell array 18 based on a decoding result.

For example, in the read operation, the sense amplifier module 20 senses the data read from the memory cell array 18 and transmits the sensed data to the data register 21. In addition, for example, the sense amplifier module 20 transmits write data to the memory cell array 18 during the write operation.

The data register 21 includes a plurality of latch circuits. The latch circuit temporarily holds the write data or read data.

For example, the column decoder 22 decodes the column address CADD during the write operation, the read operation, and the erase operation, and selects the latching circuit in the data register 21 according to the decoding result.

### [3. Configuration of Memory Cell Array]

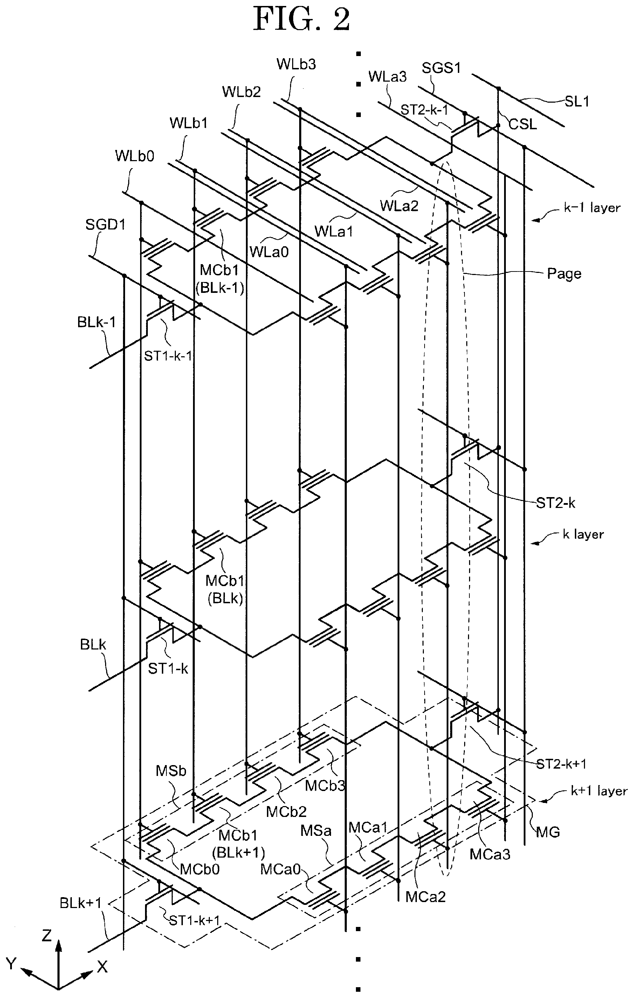

A configuration of the memory cell array 18 will be described with reference to FIG. 2. FIG. 2 is a circuit diagram showing an example of the memory cell array 18. A circuit configuration of the memory cell array 18 shown in FIG. 2 is an example, and the circuit configuration and a semiconductor layer (channel layer) of the memory cell array 18 in the non-volatile semiconductor memory device 1 are not limited to the configuration shown in FIG. 2. Configurations that are the same as or similar to those in FIG. 1 are described as necessary, and descriptions of configurations that are the same as or similar to the configurations in FIG. 1 may be omitted.

As described in "2. Configuration of Non-volatile Semiconductor Memory Device", the memory cell array 18 includes a plurality of blocks BLK. Each block BLK includes a plurality of string parts SU. Each string part SU includes a plurality of memory groups MG (memory string pairs).

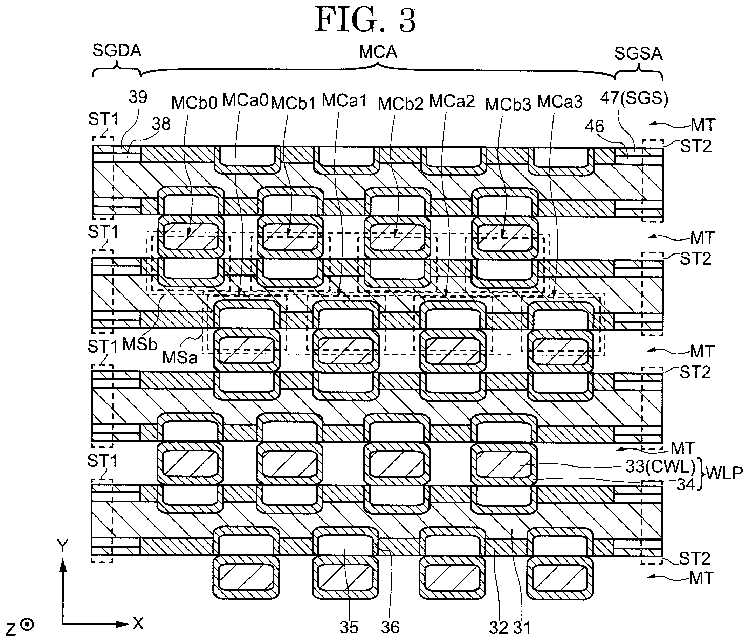

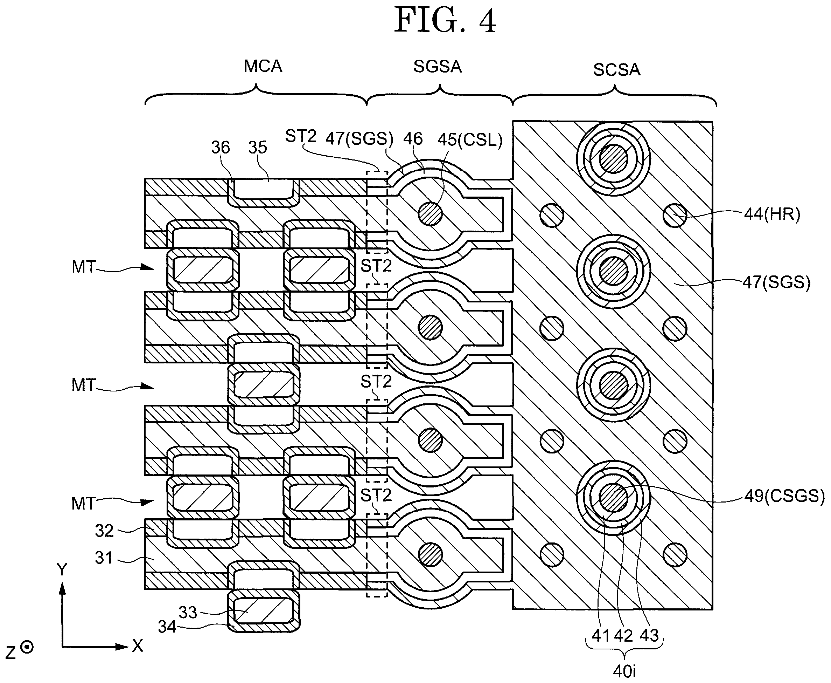

As shown in FIG. 2, the plurality of memory groups MG is stacked in a Z direction and correspond to a plurality of semiconducting layers electrically connected to bit-line contacts (not shown). For example, the plurality of memory groups MG shown in FIG. 2 corresponds to regions separated by memory trenches MT (see FIG. 3 and FIG. 4). Each of the semiconductor layers in the non-volatile semiconductor memory device 1 corresponds to the string part SU. For example, among select gate lines corresponding to a semiconductor layer 31 (the memory group MG), a drain side is denoted by "SGD", and a source side is denoted by "SGS". A channel layer (Channel) is referred to as a "semiconductor layer".

In addition, the memory cell array 18 includes a plurality of memory groups MG. More specifically, each of the semiconductor layers 31 (string parts SU) stacked in the Z direction includes a plurality of memory groups MG separated in a Y direction. Each memory group MG includes two memory strings MSa and MSb, and select transistors ST1 and ST2. In the case where the memory strings MSa and MSb in the non-volatile semiconductor memory device 1 are not distinguished from each other, the memory strings may be referred to as "memory strings MS". A select transistor ST1 in the non-volatile semiconductor memory device 1 may be referred to as a "drain-side select transistor", and the select transistor ST2 in the non-volatile semiconductor memory device 1 may be referred to as a "source-side select transistor".

For example, the memory string MSa may include four memory cell transistors MCa0, MCa1, MCa2 and MCa3. For example, like the memory string MSa, the memory string MSb includes four memory cell transistors MCb0, MCb1, MCb2 and MCb3. In the case where the memory cell transistors MCa0 to MCa3 and MCb0 to MCb3 in the non-volatile semiconductor memory device 1 are not distinguished, the memory cell transistors may be referred to as "memory cell transistors MC."

The memory cell transistor MC includes a control gate and a charge storage layer, and holds data in a non-volatile manner. The memory cell transistor MC may be a MONOS type in which an insulating layer is used for the charge storage layer, or may be an FG type in which a conductive layer is used for the charge storage layer. In an example, the memory cell transistor MC in the non-volatile memory device 1 is an FG type. Further, for example, the number of memory cell transistors MC included in each memory string MS may be 8, 16, 32, 48, 64, 96, or 128, and the number of memory strings MS is not limited to that shown in FIG. 2. A single memory cell transistor MC can be set to a threshold voltage in 2ⁿ or more ways (n is a positive integer). In this case, a plurality of memory cells, which are units of a read operation and a write operation, can hold n pages of data.

The memory cell transistors MCa0 to MCa3 contained in the memory string MSa are connected in series such that current paths of the memory cell transistors MCa0 to MCa3 contained in the memory string MSa are in series. Similar to the memory string MSa, the memory cell transistors MCb0 to MCb3 included in the memory string MSb are connected in series so that current paths of the memory cell transistors MCb0 to MCb3 included in the memory string MSb are in series. Drains of the memory cell transistors MCa0 and MCb0 are both connected to a source of the select transistor ST1. Sources of the memory cell transistors MCa3 and MCb3 are both connected to a drain of the select transistor ST2. The number of the select transistors ST1 and ST2 included in the memory group MG is optional and may be one or more. Further, for example, the memory cell transistors MCa0 to MCa3 and MCb0 to MCb3 may function as one memory string according to the dimensions of the semiconductor layer 31 functioning as a channel layer (Channel) described later. That is, the memory cell transistors MCb0, MCa0, MCb1, MCa1, MCb2, MCa2, MCb3 and MCa3 may function as one memory string connected in series.

The gates of the memory cell transistors MC in the plurality of memory groups MG arranged along the Z direction are commonly connected to one word line WL via a contact plug CWL (see FIG. 3). For example, gates (gate electrodes) of the plurality of memory cell transistors MCa0 arranged along the Z direction are connected to a common word line WLa0. Similar to the plurality of memory cell transistors MCa0, gates (gate electrodes) of the plurality of memory cell transistors MCa1, MCa2 and MCa3 are connected to common word lines WLa1, WLa2 and WLa3, respectively. Similar to the plurality of memory cell transistors MCa0, gates (gate electrodes) of the plurality of memory cell transistors MCb0 to MCb3 are respectively connected to common word lines WLb0 to WLb3. One page is composed of a plurality of memory cell transistors MC connected to the common word line WL. A plurality of data (threshold voltages) stored in the plurality of memory cell transistors MC included in one page corresponds to one page data described later.

Drains of the select transistors ST1 of the plurality of memory groups MG arranged along the Z direction are connected to bit lines BL that differ from each other. Further, gates (gate electrodes) of the select transistors ST1 of the plurality of memory groups MG arranged along the Z direction are connected to one select gate line SGD (for example, SDG1). The drains of the select transistors ST1 of the plurality of memory groups MG arranged along the Z direction are connected to the bit lines BL corresponding to different bit line contacts via the different bit line contacts (not shown). The select gate line SGD may be referred to as a "drain-side select gate line".

More specifically, for example, in the select transistor ST1 corresponding to the memory group MG arranged in the uppermost layer, the drain is connected to a bit line BLk-1, and the gate electrode is connected to a select gate line SGD1. In the select transistor ST1 corresponding to the memory group MG arranged in the lowermost layer, the drain is connected to a bit line BLk+1, and the gate electrode is connected to the select gate line SGD1. In the select transistors ST1 corresponding to the memory groups MG stacked one layer along the Z direction with respect to the memory group MG arranged in the lowermost layer, the drain is connected to the bit line BLk, and the gate electrode is connected to the select gate line SGD1.

The source of each select transistor ST2 of the plurality of memory groups MG arranged along the Z direction is connected to one source line SL1 via a contact plug (a source line contact plug CSL, a conductive layer 45, see FIG. 4). Further, the gates (gate electrodes) of the select transistors ST2 of the plurality of memory groups MG arranged along the Z direction are connected to one select gate line SGS (for example, SGS1). The select gate line SGS may be referred to as a "source-side select gate line".

In addition, although not shown, the plurality of memory groups MG arranged along the Z direction in the non-volatile semiconductor memory device 1 are also arranged along the Y direction. For example, the non-volatile semiconductor memory device 1 includes a configuration in which a plurality of memory groups MG arranged along the Z direction are arranged as one memory configuration, and a plurality of memory configurations are arranged so as to be adjacent to each other along the Y direction.

A plurality of semiconductor layers 31 (see FIG. 3 and FIG. 4) are arranged in a layer in the Z direction. The semiconductor layers 31 arranged in layers are separated in the Y direction by memory trenches MT extending in the X direction. The semiconductor layers 31 separated in the Y direction in the respective layers extend in the Z direction and the X direction to form memory groups MG. As a result, the semiconductor layers 31 arranged in a layer form a plurality of memory groups MG arranged in the Y direction. For example, the plurality of semiconductor layers 31 arranged in a layered manner in the non-volatile semiconductor memory device 1 includes semiconductor layers 31 from the first layer to the n-th layer, such as the first layer, the second layer, ..., k-1-th layer, k-th layer, k+1-th layer, ..., n-1-th layer, and the n-th layer, from the top along the Z direction. Here, the numerical value k is a natural number larger than 2, and the numerical value n is a natural number larger than a numerical value k+1. For example, the plurality of semiconductor layers 31 shown in FIG. 2 are semiconductor layers of the k-1-th layer, the k-th layer, and the k+1-th layer from the top along the Z direction.

For example, the non-volatile semiconductor memory device 1 includes a substrate (not shown) having a main surface extending in the X direction (first direction) and the Y direction (second direction) intersecting the X direction. As shown in FIG. 2, the non-volatile semiconductor memory device 1 has a semiconductor layer 31 (first channel) of the k-th layer having the bit line BLk (first bit line) arranged on one side of the substrate in the Z direction (third direction) which intersects the X direction and the Y direction and extending in the X direction, the source line SL1 arranged on one side of the substrate in the Z direction and extending in the Y direction and the Z direction, a select transistor ST1-k (first drain-side select transistor) arranged on one side of the substrate in the Z direction, extending in the X direction, and connected with the bit line BLk, a select transistor ST2-k (first source-side select transistor) connected with the source line SL1, and a memory cell transistor MCb1 (BLk) (first memory cell transistor) connected between the select transistor ST1-k and the select transistor ST2-k, a semiconductor layer 31 (second channel) of the k-1-th layer having a select transistor ST1-k-1 (second drain-side select transistor) connected with the bit line BLk-1 (second bit line) arranged on one side (upper side) of the k-th semiconductor layer 31 in the Z direction, extending in the X direction, and which is different from the bit line BLk, a select transistor ST2-k-1 (second source-side select transistor) connected to the source line SL1, and a memory cell transistor MCb1 (BLk-1) (second memory cell transistor) connected between the select transistor ST1-k-1 and the select transistor ST2-k-1, a semiconductor layer 31 (third channel) of the k+1-th layer having a select transistor ST1-k+1 (third drain-side select transistor) arranged on the opposite side of the k-1th semiconductor layer 31 in the Z direction with respect to the kth semiconductor layer 31, extending in the X direction, and connected to the bit line BLk+1 (third bit line) different from the bit line BLk-1 and the bit line BLk-1, a select transistor ST2-k+1 (third source-side select transistor) connected to the source line SL1, and a memory cell transistor MCb1 (BLk+1) (third memory cell transistor) connected between the select transistor ST1-k+1 and the select transistor ST2-k+1, and a word line WLb1 functioning as a gate (gate electrode) of the memory cell transistor Mcb1 (BLk+1), a gate (gate electrode) of the memory cell transistor MCb1 (BLk), and a gate (gate electrode) of the memory cell transistor MCb1 (BLk-1).

### [4. Structure of Memory Cell Region, Part of SGD Region, SGS Region, and Staircase Contact Region]

Referring to FIG. 3 and FIG. 4, an exemplary planar configuration of a part of a memory cell region MCA, an SGD region SGDA and an SGS region SGSA will be described. FIG. 3 is a plan view showing a part of the memory cell region MCA, the SGD region SGDA and a part of the SGS region SGSA of the memory cell array 18. FIG. 4 is a plan view showing an exemplary staircase contact region SCSA corresponding to the memory cell region MCA, the SGS region SGSA and the select gate line SGS of the memory cell array 18. The planar configuration of each region of the memory cell array 18 in the non-volatile semiconductor memory device 1 shown in FIG. 3 and FIG. 4 is an example, and the planar configuration of each region of the memory cell array 18 in the non-volatile semiconductor memory device is not limited to the example shown in FIG. 3 and FIG. 4. Configurations that are the same as or similar to those in FIG. 1 and FIG. 2 are described as necessary, and descriptions of configurations that are the same as or similar to those in FIG. 1 and FIG. 2 may be omitted.

As shown in FIG. 3, the memory trench MT is provided between the semiconductor layers 31 arranged adjacent to each other along the Y direction. Insulating layers (not shown) are embedded in the memory trench MT.

An insulating layer 32 is provided on a side surface of the semiconductor layer 31 in the memory cell region MCA. The insulating layer 32 functions as an etching stopper when forming an insulating layer 36 (tunnel insulating film) and a charge storage layer 35, which will be described later.

Further, a plurality of word line pillars WLP in the memory cell region MCA are provided so as to separate the memory trenches MT. The word line pillar WLP includes a conductive layer 33 extending in the Z direction and an insulating layer 34 contacting a side surface of the conductive layer 33. The conductive layer 33 functions as a contact plug CWL. The insulating layer 34 functions as a blocking insulating film of the memory cell transistor MC.

The charge storage layer 35 and the insulating layer 36 are provided between the word line pillar WLP and the semiconductor layer 31 so as to separate the insulating layer 32 along the Y direction. The insulating layer 36 functions as a tunnel insulating film. More specifically, one side surface of the charge storage layer 35 along the X direction is in contact with the insulating layer 34 of the word line pillar WLP, and the other side surfaces are in contact with the insulating layer 36, in an XY plane. The other side surfaces are the other side surface along the X direction and the two side surfaces along the Y direction. Part of the side surfaces of the insulating layer 36 is in contact with the semiconductor layer 31 and the insulating layer 32.

Therefore, the insulating layer 34, the charge storage layer 35 and the insulating layer 36 are formed in this order from the conductive layer 33 toward the semiconductor layer 31, between the conductive layer 33 and the semiconductor layer 31. A region including a part of the semiconductor layer 31, a part of the conductive layer 33, a part of the insulating layer 34, the charge storage layer 35, and the insulating layer 36 functions as the memory cell transistor MC. A region including a part of the semiconductor layer 31, a part of the conductive layer 33, a part of the insulating layer 34, the charge storage layer 35, and the insulating layer 36 is also referred to as an "intersection region between the semiconductor layer 31 and the word line pillar WLP". In the embodiment shown in FIG. 3, in one semiconductor layer 31, an intersection region between the semiconductor layer 31 and the word line pillar WLP provided on a lower side of a paper surface of FIG. 3 functions as the memory string MSa (memory cell transistor MCa), and an intersection region between the semiconductor layer 31 and the word line pillar WLP provided on an upper side of the paper surface of FIG. 3 functions as the memory string MSb (memory cell transistor MCb). Further, for example, the plurality of memory cell transistors MCa corresponding to one semiconductor layer 31 are arranged in the order MCa0, MCa1, ... from the SGD region SGDA toward the SGS region SGSA. Similar to the memory cell transistor MCa, the memory cell transistors MCb are arranged in order MCb0, MCb1, ... from the SGD region SGDA toward the SGS region SGSA.

Further, for example, as shown in FIG. 4, the memory cell region MCA and the SGS region SGSA of the memory cell array 18 may have a configuration in which the four semiconductor layers 31 are independently connected in the vicinity of the SGS region SGSA, and the conductive layer 45 penetrating the semiconductor layer 31 may be provided in the SGS region SGSA. The conductive layer 45 functions as a source line contact plug CSL. The semiconductor layer 31 has a circular shape in a connection region with the conductive layer 45. In addition, the shape of the semiconductor layer 31 in the connection region with the conductive layer 45 is arbitrary. For example, the shape of the connection region may be a polygon. The connection regions may be formed in such a manner that, when holes of the source line contact plug CSL penetrating the semiconductor layer 31 are processed, sufficient margins for preventing the holes of the source line contact plug CSL from protruding from the semiconductor layer 31 due to manufacturing variations or the like can be secured in the XY plane.

Similar to the insulating layer 32 in the memory cell region MCA, an insulating layer 46 is provided so as to surround the side surface of the semiconducting layer 31 in the SGS region SGSA. That is, the insulating layer 46 is provided so as to be in contact with the side surface of the semiconductor layer 31. Insulating layers 46 function as a gate insulating film of the select transistors ST2-k-1 to ST2-k+1. In the insulating layer 46, a side surface opposing the side surface in contact with the semiconductor layer 31 is in contact with a conductive layer 47. Further, for example, SiO₂ is used for the insulating layers 46. The insulating layers 46 are preferably formed of a SiON film. For example, in the case where adjustment of threshold values of the select transistors ST2-k-1 to ST2-k +1 is required, the insulating layer 46 is preferably formed of a three-layer ONO film in which SiO₂, SiN, and SiO₂ are stacked instead of the SiON film.

The conductive layer 47 functions as the select gate line SGS. More specifically, the conductive layer 47 includes a first portion extending in the Y direction, and a plurality of second portions in the SGS region SGSA in which one side surface is in contact with the insulating layer 46 and an end portion is in contact with the first portion of the conductive layer 47. A conductive material is used for the conductive layer 47. The conductive material may be, for example, a metallic material, a semiconductor such as Si doped with impurities, or polysilicon doped with phosphorus (P).

In the SGS region SGSA, a region including the semiconductor layer 31, the insulating layer 46, and the second portions of the conductive layer 47 from the memory cell region MCA to the conductive layer 45 functions as the select transistor ST2. More specifically, the second portions of the conductive layer 47 function as a gate electrode of the select transistor ST2, the insulating layer 46 functions as a gate insulating film of the select transistor ST2, and channels of the select transistor ST2 are formed in the semiconductor layer 31.

A conductive layer 49 and an insulating layer 44 penetrating the first portion of the conductive layer 47 are arranged in the staircase contact region SCSA. The conductive layer 49 functions as a contact plug CSGS. The insulating layer 44 functions as a dummy pillar HR. For example, the conductive layer 49 is connected to each of the first portions of the conductive layers 47 stacked in the Z direction. An insulating layer 40i is formed between the conductive layer 47 and the conductive layer 49 which are not connected. The insulating layer 40i includes insulating layers 41, 42, and 43. The insulating layer 41 is arranged so as to be in contact with a side surface of the conductive layer 49. The side surface of the conductive layer 49 is also referred to as an "outer surface". The insulating layer 42 is arranged so as to be in contact with a part of an outer surface of the insulating layer 41. The insulating layer 43 is provided so as to be in contact with the outer surface of the insulating layer 42. A conductive material is used for the conductive layer 49. The conductive material may be, for example, a metallic material, and more specifically, W and TiN may be used. For example, the staircase contact region SCSA is a region in which a plurality of select gate lines SGS (a plurality of select gate lines SGS including select gate lines SGS0, SGS1, SGS2, SGS3, ...) is provided in a staircase shape.

Further, for example, as shown in FIG. 3, an insulating layer 38 in the SGD region SGDA is arranged so as to surround the side surface of the semiconducting layer 31, similar to the insulating layer 46 in the SGS region SGSA. The insulating layer 38 functions as a gate insulating film of the select transistors ST1. The insulating layer 38 may be made of the same insulating material as the insulating layer 46.

In the insulating layer 38, a side surface opposing the side surface in contact with the semiconductor layer 31 is in contact with a conductive layer 39. The conductive layer 39 functions as the select gate line SGD. More specifically, the conductive layer 39 includes a first portion (not shown) extending in the Y direction, and a plurality of second portions in which one side surface contacts the insulating layer 38 and an end portion contacts the first portion of the conductive layer 39 in the SGD region SGDA. The conductive layer 39 may be made of the same conductive material as the conductive layer 47.

Further, for example, similar to the select transistor ST2 in the SGS region SGSA, in the SGD region SGDA, a region including the semiconductor layer 31, the insulating layer 38, and the second portions of the conductive layer 39 from the memory cell region MCA to the conductive layer 39 functions as the select transistor ST1. More specifically, the second portions of the conductive layer 39 function as a gate electrode of the select transistor ST1, the insulating layer 38 functions as a gate insulating film of the select transistor ST1, and channels of the select transistor ST1 are formed in the semiconductor layer 31.

Further, although not shown, for example, similar to the SGS region SGSA, conductive layers independently connected to each of the four semiconductor layers 31 in the SGD region SGDA, penetrating the semiconductor layers 31 not connected among the four semiconductor layers and functioning as a contact plug may be provided in the SGD region SGDA. The semiconductor layers 31 in the SGD region SGDA may have a circular shape in the connection region with the conductive layers functioning as the contact plug. In addition, the conductive layer functioning as the contact plug may be made of the same conductive material as the conductive layer 45 (source line contact plug CSL). Further, although not shown, a staircase contact region corresponding to the SGD region SGDA may be provided on the side of the SGD region SGDA, similar to the staircase contact region SCSA on the side of the SGS region SGSA. The staircase contact region corresponding to the SGD region SGDA is a staircase contact region corresponding to the select gate line SGD, and is, for example, a region in which a plurality of select gate lines SGD (a plurality of select gate lines SGD including select gate lines SGD0, SGD1, SGD2, SGD3, ...) is provided in a staircase shape.

### [5. Circuit Configuration of Sense Amplifier Part]

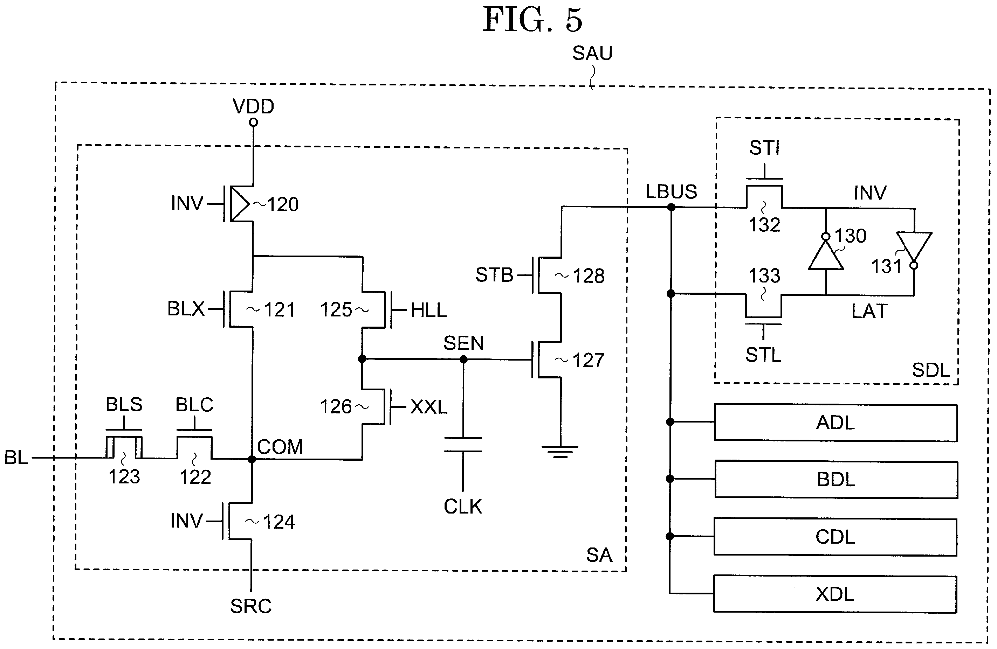

Referring to FIG. 5, an exemplary circuit configuration of a sense amplifier part SAU will be described. FIG. 5 is an exemplary circuit configuration of the sense amplifier part SAU. In addition, the circuit configuration of the sense amplifier part SAU shown in FIG. 5 is an example, and the circuit configuration of the sense amplifier part SAU of the non-volatile semiconductor memory device 1 is not limited to the example shown in FIG. 5. Descriptions of the same or similar configurations as those in FIG. 1 to FIG. 4 are described as necessary, and descriptions of the same or similar configurations as those in FIG. 1 to FIG. 4 may be omitted.

The sense amplifier module 20 includes a plurality of sense amplifier parts SAU each associated with bit lines BL1 to BLm (m is a natural number equal to or greater than 2). FIG. 5 shows a circuit configuration of one sense amplifier part SAU.

For example, the sense amplifier part SAU can temporarily hold data read out to the corresponding bit line BL. In addition, the sense amplifier part SAU can perform a logical operation using temporarily stored data, and can temporarily hold data subjected to the logical operation. For example, the non-volatile semiconductor memory device 1 can perform a read operation and a write operation using the sense amplifier module 20 (sense amplifier part SAU).

As shown in FIG. 5, the sense amplifier part SAU includes a sense amplifier part SA, and latch circuits SDL, ADL, BDL, CDL, and XDL. The sense amplifier part SA, and the latch circuits SDL, ADL, BDL, CDL, and XDL are connected by a bus LBUS so as to be able to transmit and receive data to and from each other.

For example, the sense amplifier part SA senses the data read to the corresponding bit line BL, and determines whether the read data is "0" or "1", in the read operation. For example, the sense amplifier part SA includes a p-channel MOS transistor 120, n-channel MOS transistors 121 to 128, and a capacitor 129.

One end of the transistor 120 is connected to a power supply line, and a gate of the transistor 120 is connected to a node INV in the latch circuit SDL. One end of the transistor 121 is connected to the other end of the transistor 120, the other end of the transistor 121 is connected to a node COM, and a control signal BLX is input to a gate of the transistor 121. One end of the transistor 122 is connected to the node COM, and a control signal BLC is input to a gate of the transistor 122. The transistor 123 is a high breakdown voltage MOS transistor, and one end of the transistor 123 is connected to the other end of the transistor 122, the other end of the transistor 123 is connected to a corresponding bit line BL, and a gate of the transistor 123 receives a control signal BLS.

One end of the transistor 124 is connected to the node COM, the other end of the transistor 124 is connected to a node SRC, and a gate of the transistor 124 is connected to the node INV. One end of the transistor 125 is connected to the other end of the transistor 120, the other end of the transistor 125 is connected to a node SEN, and a control signal HLL is input to a gate of the transistor 125. One end of the transistor 126 is connected to the node SEN, the other end of the transistor 126 is connected to the node COM, and a control signal XXL is input to a gate of the transistor 126.

One end of the transistor 127 is grounded, and a gate of the transistor 127 is connected to the node SEN. One end of the transistor 128 is connected to the other end of the transistor 127, the other end of the transistor 128 is connected to the bus LBUS, and a control signal STB is input to a gate of the transistor 128. One end of the capacitor 129 is connected to the node SEN, and the other end of the capacitor 129 receives the clock CLK.

For example, the control signals BLX, BLC, BLS, HLL, XXL, and STB are generated by the sequencer 15. Further, for example, a voltage VDD (second voltage), which is an internal power supply voltage of the non-volatile semiconductor memory device 1, is applied to the power supply line connected to one end of the transistor 120. Further, for example, a voltage VSS (first voltage) of the non-volatile semiconductor memory device 1 is applied to the node SRC. For example, the voltage VSS is a voltage capable of defining another voltage with reference to the voltage VSS, and the voltage VSS may be a reference voltage, 0 V, or a ground potential.

The latch circuits SDL, ADL, BDL, CDL, and XDL temporarily hold the read data. For example, the latch circuit XDL is connected to the data register 21 and is used to input and output data between the sense amplifier part SAU and the input-output circuit 10.

For example, the latch circuit SDL includes inverters 130 and 131 and n-channel MOS transistors 132 and 133. An input node of the inverter 130 is connected to a node LAT, and an output node of the inverter 130 is connected to the node INV. An input node of the inverter 131 is connected to the node INV, and an output node of the inverter 131 is connected to the node LAT. One end of the transistor 132 is connected to the node INV, the other end of the transistor 132 is connected to the bus LBUS, and a control signal STI is input to a gate of the transistor 132. One end of the transistor 133 is connected to the node LAT, the other end of the transistor 133 is connected to the bus LBUS, and a control signal STL is input to a gate of the transistor 133. For example, the data held in the node LAT corresponds to the data held in the latch circuit SDL, and the data held in the node INV corresponds to the inverted data of the data held in the node LAT. Circuit configurations of the latch circuits ADL, BDL, CDL and XDL are the same as the circuit configuration of the latch circuit SDL, for example, and therefore will not be described.

The timing at which each of the sense amplifier parts SAU in the sense amplifier module 20 determines the data read to the bit line BL is based on a timing at which the control signal STB is asserted. In this specification and the like, "the sequencer 15 asserts the control signal STB" corresponds to the sequencer 15 changing the control signal STB from an "L" level to an "H" level.

In addition, the configuration of the sense amplifier module 20 in the non-volatile semiconductor memory device 1 is not limited to the configuration shown in FIG. 5. For example, in the sense amplifier part SAU, the transistor 128 to which the control signal STB is input may be a p-channel MOS transistor. Here, "the sequencer 15 asserts the control signal STB" corresponds to the sequencer 15 changing the control signal STB from the "H" level to the "L" level.

Further, the number of latch circuits included in the sense amplifier part SAU can be set to any number. For example, in this case, the number of latching circuits is designed based on the number of bits of data held by one memory cell transistor MC. Further, a plurality of bit lines BL may be connected to one sense amplifier part SAU via selectors.

### [6. Threshold Distribution of Memory Cell Transistor]

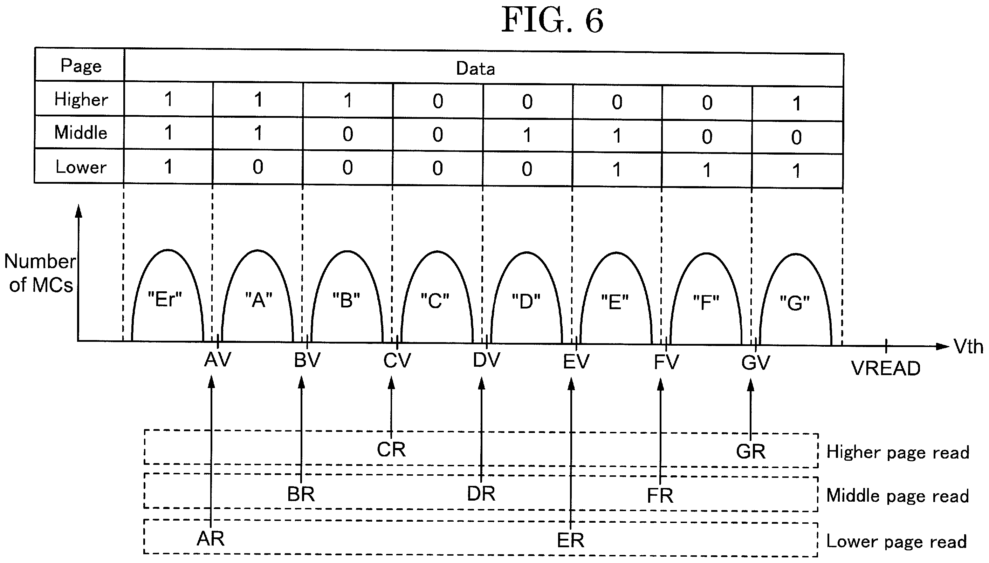

Referring to FIG. 6, an exemplary threshold distribution of the memory cell transistor MC will be described. FIG. 6 is a threshold distribution diagram showing an exemplary threshold distribution of the memory cell transistor MC. It should be noted that the threshold distribution of the memory cell transistor MC of the non-volatile semiconductor memory device 1 is not limited to the example shown in FIG. 6. Configurations that are the same as or similar to those in FIG. 1 to FIG. 5 are described as necessary, and descriptions of configurations that are the same as or similar to those in FIG. 1 to FIG. 5 may be omitted.

For example, the non-volatile memory device 1 uses a TLC (Triple-Level Cell) method in which three bit data is stored in one memory cell transistor MC as a write method of the memory cell transistor MC.

FIG. 6 is a diagram showing exemplary data allocation, a read voltage, and a verify voltage of the memory cell transistor MC in the TLC method. A vertical axis of the threshold value shown in FIG. 6 corresponds to the number of memory cell transistors MC (Number of MCs), and a horizontal axis corresponds to a threshold value Vth of the memory cell transistor MC.

As shown in FIG. 6, the plurality of memory cell transistors MC in the TLC method form eight threshold distributions. The eight threshold distributions (write level and program target level) are referred to as "Er" level, "A" level, "B" level, "C" level, "D" level, "E" level, "F" level, and "G" level in order from the lower threshold voltage. Different three bit data are assigned to the "Er" level, "A" level, "B" level, "C" level, "D" level, "E" level, "F" level, and "G" level, for example, as shown below.
"Er" level: "111" ("Lower bit / Middle bit / High bit") data
"A" level: "011" data
"B" level: "001" data
"C" level: "000" data
"D" level: "010" data
"E" level: "110" data
"F" level: "100" data
"G" level: "101" data
That is, the TLC corresponds to a case where a value n is 3 among 2ⁿ (n is a positive integer) or more threshold voltages that can be set for one memory cell transistor MC.

Between adjacent threshold distributions, a verify voltage used in each write operation is set. Specifically, verify voltages AV, BV, CV, DV, EV, FV and GV are set corresponding to the "A" level, the "B" level, the "C" level, the "D" level, the "E" level, the "F" level, and the "G" level, respectively.

For example, the verify voltage AV is set between a maximum threshold voltage at the "Er" level and a minimum threshold voltage at the "A" level. When the verify voltage AV is applied to the memory cell transistor MC, the memory cell transistor MC including the threshold voltage at the "Er" level is changed to an on-state, and the memory cell transistor MC including the threshold voltage at the "A" level or higher is changed to an off-state.

Further, for example, the other verify voltages BV, CV, DV, EV, FV and GV are also set in the same manner as the verify voltage AV. The verify voltage BV is set between "A" level and "B" level, the verify voltage CV is set between "B" level and "C" level, the verify voltage DV is set between "C" level and "D" level, the verify voltage EV is set between "D" level and "E" level, the verify voltage FV is set between "E" level and "F" level, and the verify voltage GV is set between "F" level and "G" level.

For example, the verify voltage AV may be set to 0.8 V, the verify voltage BV may be set to 1.6 V, the verify voltage CV may be set to 2.4 V, the verify voltage DV may be set to 3.1 V, the verify voltage EV may be set to 4.6 V, and the verify voltage GV may be set to 5.6 V. In addition, the verify voltages AV, BV, CV, DV, EV, FV, and GV are not limited to the examples shown here. For example, the verify voltages AV, BV, CV, DV, EV, FV, and GV may be set in stages as appropriate within a range of 0 V to 7.0 V.

In addition, a read voltage used in each read operation may be set between adjacent threshold distributions. For example, a read voltage AR for determining whether the threshold voltage of the memory cell transistor MC is included in the "Er" level or is included in the "A" level or higher is set between the maximum threshold voltage at the "Er" level and the minimum threshold voltage at the "A" level.

The other read voltages BR, CR, DR, ER, FR and GR may be set in the same manner as the read voltage AR. For example, the read voltage BR is set between "A" level and "B" level, the read voltage CR is set between "B" level and "C" level, the read voltage DR is set between "C" level and "D" level, the read voltage ER is set between "D" level and "E" level, the read voltage FR is set between "E" level and "F" level, and the read voltage GR is set between "F" level and "G" level.

In addition, a read pass voltage VREAD is set to a voltage higher than the maximum threshold voltage of the highest threshold distribution (for example, "G" level). The memory cell transistor MC having the read pass voltage VREAD applied thereto is changed to an on-state regardless of the data to be stored.

In addition, for example, the verify voltages AV, BV, CV, DV, EV, FV, and GV are set to voltages higher than the read voltages AR, BR, CR, DR, ER, FR, and GR, respectively. That is, the verify voltages AV, BV, CV, DV, EV, FV, and GV are set near the lower tail of the threshold distributions of the "A" level, "B" level, "C" level, "D" level, "E" level, "F" level, and "G" level, respectively.

For example, in the case where the allocation of data described above is applied, lower-bit one-page data (lower page data) in the read operation is determined based on the read data using the read voltages AR and ER. Middle-bit one-page data (middle page data) is determined by read-out results using the read voltages BR, DR, and FR. Higher-bit one-page data (higher page data) is determined by the read data using the read voltages CR and GR. As described above, since the lower page data, the middle page data, and the higher page data are determined by two, three, and two read operations, respectively, this data allocation is referred to as "2-3-2 code".

In addition, the number of bits of data to be stored in one memory cell transistor MC and the allocation of data to the threshold distribution of the memory cell transistor MC described with reference to FIG. 6 are examples, and are not limited to the examples shown in FIG. 6. For example, 2 bits or 4 bits or more of data may be stored in one memory cell transistor MC. Further, the read voltage and the read pass voltage may be set to the same voltage value in each method, or may be set to different voltage values.

### [7. Overview of Write and Read Operations]

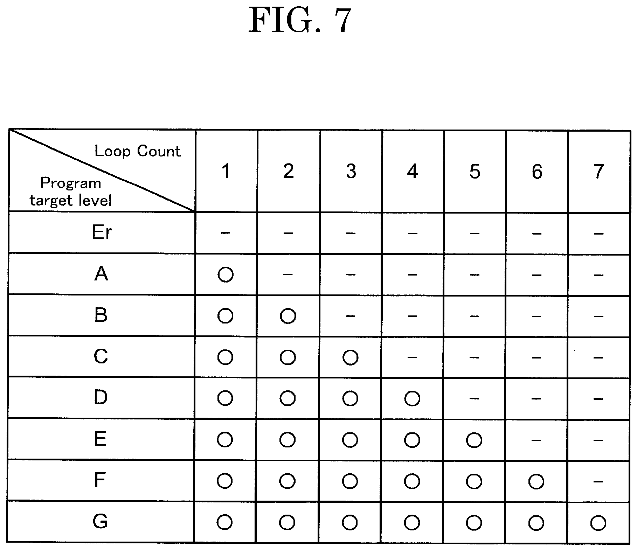

A method for operating the memory cell array shown in FIG. 2 will be described with reference to FIG. 7. FIG. 7 is a diagram showing an example of a program loop in the non-volatile semiconductor memory device 1. In addition, the program loop of the non-volatile semiconductor memory device 1 is not limited to the example shown in FIG. 7. Configurations that are the same as or similar to those in FIG. 1 to FIG. 6 are described as necessary, and descriptions of configurations that are the same as or similar to those in FIG. 1 to FIG. 6 may be omitted.

For example, as described in "3. Configuration of Memory Cell Array", if the number of layers of the plurality of semiconductor layers 31 is the number of layers n, the regions separated by the memory trench MT include n memory groups MG stacked in the Z direction. The string parts SU constitute one block BLK that operates simultaneously. The write operation, the read operation, and the erase operation are executed in block units BLK.

The non-volatile semiconductor memory device 1 repeatedly executes a program loop in the write operation. The program loop includes a program operation and a verify operation. The program operation is an operation of injecting electrons into a charge storage layer in the selected memory cell transistor MC to increase the threshold voltage of the selected memory cell transistor MC. Alternatively, the program operation is an operation of maintaining the threshold voltage of the selected memory cell transistor MC by prohibiting injecting electrons into the charge storage layer. The verify operation is an operation of checking whether or not the threshold voltage of the selected memory cell transistor MC has reached a target level by performing a read operation using the verify voltage following the program operation. The selected memory cell transistor MC whose threshold voltage has reached the target level is then write-protected.

The non-volatile semiconductor memory device 1 repeatedly executes the program loop including the program operation and the verify operation described above, so that the threshold voltage of the selected memory cell transistor MC rises to the target level.

Electrons accumulated in the charge storage layer may be accumulated in an unstable state. Therefore, the electrons accumulated in the charge storage layer of the memory cell transistor MC may escape from the charge storage layer as time elapses from the time when the program operation described above is completed. As the electrons escape from the charge storage layer, the threshold voltage of the memory cell transistor MC decreases. Therefore, in the read operation executed after the completion of the write operation, the non-volatile semiconductor memory device 1 performs the read operation using a read voltage lower than the verify voltage in order to cope with such a decrease in the threshold voltage of the memory cell transistor that may occur as time elapses. In addition, the read operation may include the verify operation. Further, in this specification and the like, each operation of the non-volatile semiconductor memory device 1 is included in each operation method. More specifically, the write operation of the non-volatile semiconductor memory device 1 is included in a write operation method, the read operation of the non-volatile semiconductor memory device 1 is included in a read operation method, the erase operation of the non-volatile semiconductor memory device 1 is included in an erase operation method, and the verify operation of the non-volatile semiconductor memory device 1 is included in a verify operation method.

For example, an exemplary program loop shown in FIG. 7 indicates a program target level ("Er" level to "G" level) in a vertical direction, and indicates the number of times the program loop is executed in the non-volatile semiconductor memory device 1 (the number of loops) in a lateral direction. In addition, "O" shown in FIG. 7 indicates the program target level to which a program operation in each loop is to be performed, and "-" shown in FIG. 7 indicates a program target level to which a program operation in each loop is not to be performed.

For example, as shown in FIG. 7, the number of loops in the non-volatile semiconductor memory device 1 is seven. Further, referring to FIG. 7, the memory cell transistor MC targeted at the "A" level is subject to the program operation in the first loop, and is not subject to the program operation in the second and subsequent loops. Similar to the memory cell transistor MC targeted at the "A" level, the memory cell transistor MC targeted at the "B" level is subject to a program operation in the first loop and the second loop, and is not subject to a program operation in the third and subsequent loops. The memory cell transistors MC targeting the "C" level to the "G" level are subject to program operations according to the number of loops, similar to the memory cell transistor MC targeting the "A" level and the memory cell transistor MC targeting the "B" level.

### [7-1. Example of Write Operation]

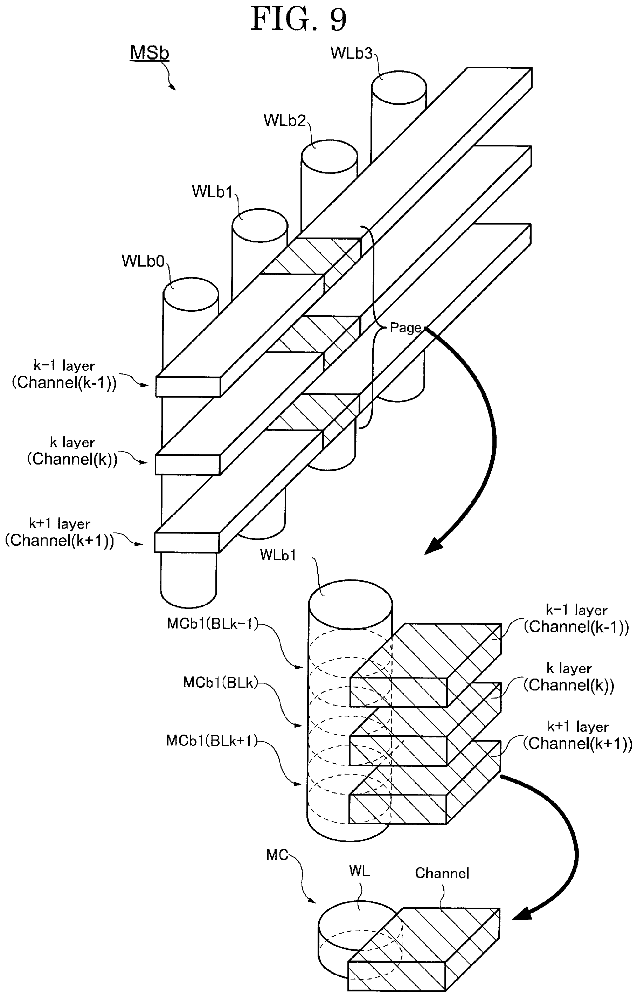

Referring to FIG. 2, FIG. 8 to FIG. 11, an example of a write operation of a non-volatile semiconductor device in a comparative example will be described. Referring to FIG. 2, FIG. 9,

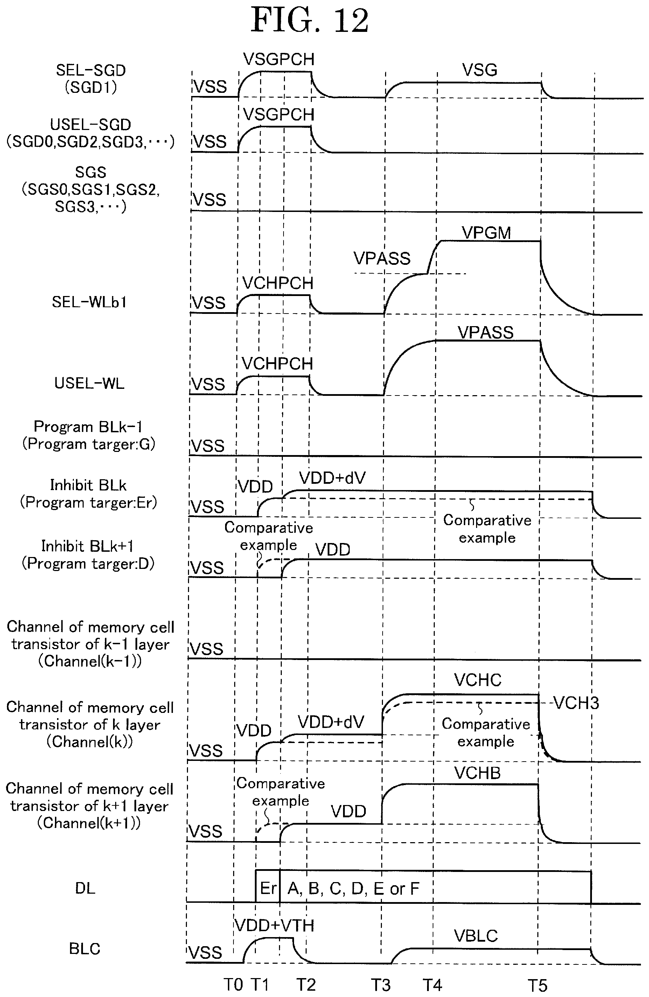

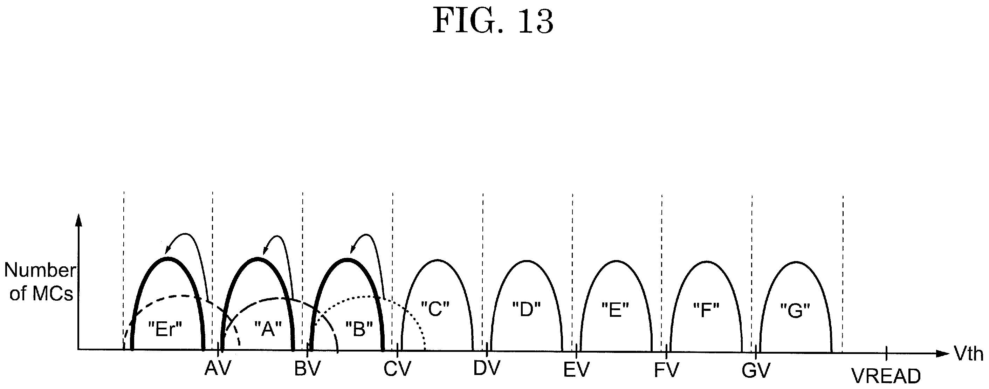

FIG. 12, and FIG. 13, an example of a write operation in the memory cell array 18 of the non-volatile semiconductor memory device 1 will be described.

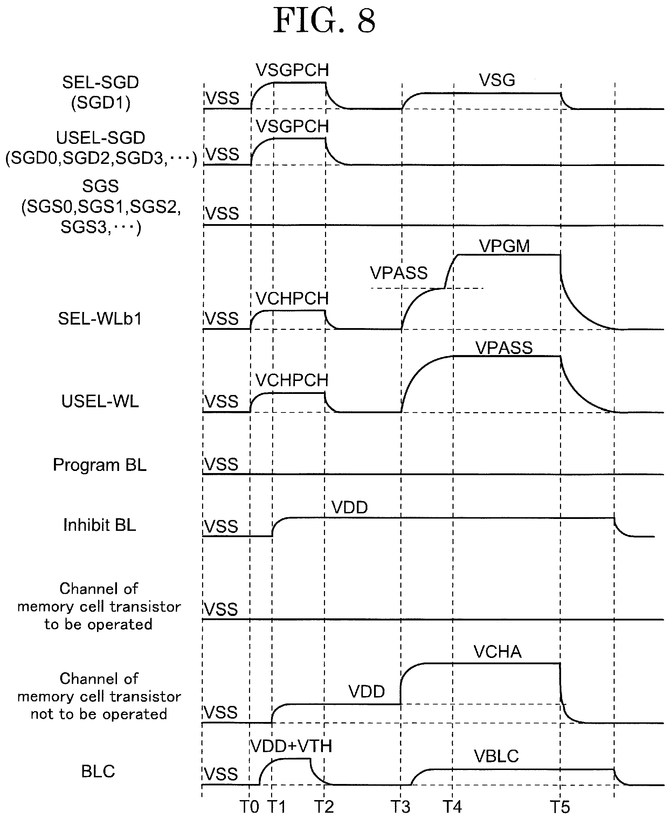

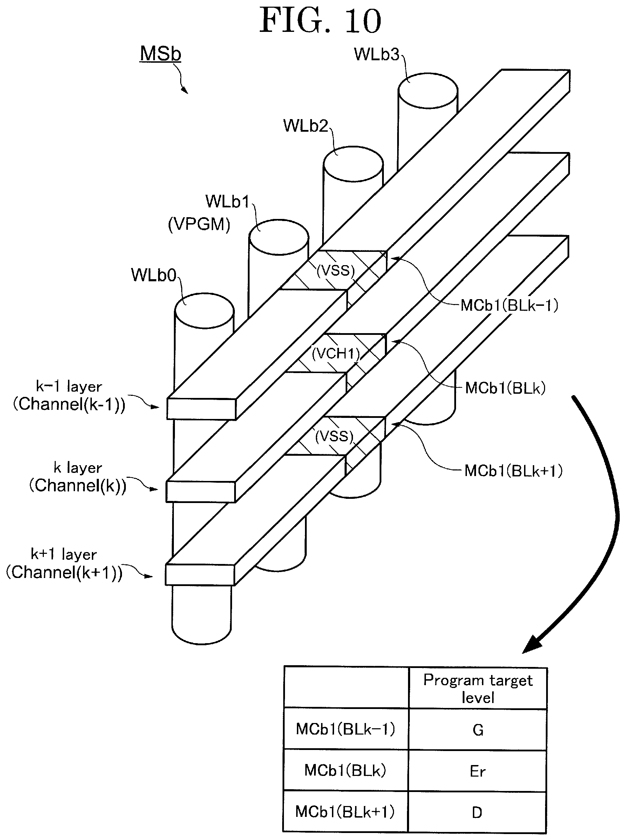

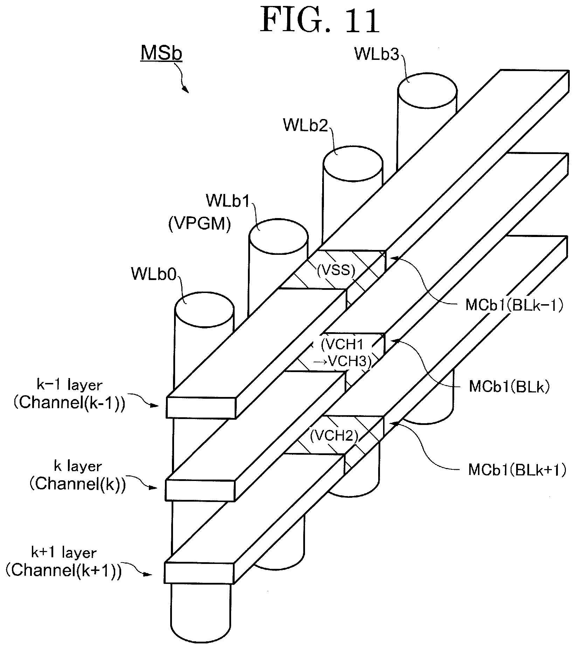

FIG. 8 is a timing chart showing an example of the write operation in the non-volatile semiconductor memory device according to the comparative example, and is a timing chart showing an example of a temporal change in voltages applied to various circuit components. FIG. 9 is a perspective view showing an exemplary channel layer in the non-volatile semiconductor memory device 1, and is a schematic view focusing on the memory string MSb among the memory strings of the semiconductor layers 31 shown in FIG. 2. FIG. 10 and FIG. 11 are schematic diagrams showing an example of a state of a channel layer in the non-volatile semiconductor memory device according to the comparative example. FIG. 12 is a diagram showing a timing chart of the write operation in the memory cell array 18 of the non-volatile semiconductor memory device 1, and shows a timing chart showing an example of a temporal change in voltages applied to various circuit components. FIG. 13 is a threshold distribution diagram showing an exemplary threshold distribution of the memory cell transistor MC.

In addition, the timing charts shown in FIG. 8 and FIG. 12 are merely timing charts showing exemplary temporal changes in voltages applied to various circuit components, and do not necessarily accurately show changes in voltages supplied to the word line WL, and the potential of the select gate lines SGD and SGS, and the like. In addition, a perspective view showing a channel layer and a view showing the state of the channel layer shown in FIG. 9 to FIG. 12, and a threshold distribution of the memory cell transistor MC of the non-volatile semiconductor memory device 1 shown in FIG. 13 are schematically shown, and a perspective view of the channel layer and a view showing the state of the channel layer, and a threshold distribution of the memory cell transistor MC of the non-volatile semiconductor memory device 1 are not limited to the examples shown in FIG. 9 to FIG. 13. Further, the same or similar configurations as those in FIG. 1 to FIG. 7 are described as necessary, and description of the same or similar configurations as those in FIG. 1 to FIG. 7 may be omitted. Further, in describing the write operation of the non-volatile semiconductor device in the comparative example, in the case where the non-volatile semiconductor device in the comparative example includes the same configuration as that of the non-volatile semiconductor memory device 1, the description will be made using the same components as those of the non-volatile semiconductor memory device 1.

In the following explanation, the memory string MSb among the memory strings of the respective semiconductor layer 31 will be focused on. The select gate lines SGD connected to the memory cell transistors MC to be operated in the respective memory strings MS are referred to as select gate lines SEL-SGD, and the select gate lines SGD connected to the other memory cell transistors MC are referred to as non-select gate lines USEL-SGD. The word lines WL connected to the memory cell transistors MC to be operated in each memory string MS are referred to as select word lines SEL-WL, and the other word lines connected to the memory cell transistors MC are referred to as non-select word lines USEL-WL. Among the memory strings of the semiconductor layers 31, the bit lines BL connected to the memory strings including the memory cell transistors MC to be operated are referred to as bit lines Program BL. Bit lines BL connected to memory strings including memory cell transistors MC other than the memory cell transistors MC to be operated are referred to as bit lines Inhibit BL. In addition, in the write operation, the voltage supplied to the select gate line SGS connected to the memory cell transistor MC in each memory string MS is the voltage VSS, and the select gate line SGS is not distinguished by the memory cell transistor MC in each memory string MS and is referred to as the "select gate line SGS".

For example, the memory cell transistors MC to be operated are memory cell transistors MC to which data (threshold voltage) is written, and the memory cell transistors MC other than the memory cell transistors MC to be operated are memory cell transistors MC to which data (threshold voltage) is not written. For example, memory cell transistors MC other than the memory cell transistors MC to be operated are referred to as "memory cell transistors not to be operated".

In addition, each of the plurality of bit lines BL (for example, BLk-1, BLk, BLk+1) is connected to a sense amplifier part SAU corresponding to each of the plurality of bit lines BL. Further, for example, as shown in FIG. 6, the transistor 122 included in the sense amplifier part SAU is controlled to be in the on-state and the off-state based on the voltage supplied to the control signal BLC, and the transistor 123 included in the sense amplifier part SAU is controlled to be in the on-state and the off-state based on the voltage supplied to the control signal BLS, and if transistor 123 is in the on-state, the sense amplifier part SAU supplies data (threshold voltage) stored in the voltage VDD, and the latch circuits SDL, ADL, BDL, CDL, or XDL to the bit line BL. In addition, an operation of the transistor 123 in the write operation in the memory cell array 18 of the non-volatile semiconductor memory device 1 is the same as the operation of the transistor 122, and in the description of the write operation in the memory cell array 18 of the non-volatile semiconductor memory device 1, the operation of the transistor 122 is described, and the description of the operation of the transistor 123 is omitted.

Further, for example, as shown in the memory string MSb of FIG. 9, the semiconductor layer 31 of the k+1-th layer is denoted as the channel layer (k+1) (Channel(k+1)), the semiconductor layer 31 of the k-th layer is denoted as the channel layer (k) (Channel (k)), and the semiconductor layer 31 of k-1-th layer is denoted as the channel layer (k-1) (Channel (k-1)). Here, referring to FIG. 2 and FIG. 9, the bit line BL and the select gate lines SGD and SGS connected to the Channel (k+1) are the bit line BLk+1 and the select gate lines SGD1 and SGS1, the bit line BL and the select gate lines SGD and SGS connected to the Channel (k) are the bit line BLk and the select gate lines SGD1 and SGS1, and the bit line BL and the select gate lines SGD and SGS connected to the Channel (k-1) are the bit line BLk-1 and the select gate lines SGD1 and SGS1. Further, each of the select gate lines SGD and SGS is supplied with the voltage shown in FIG. 8 or 12.

Referring to FIG. 2 and FIG. 9, the memory cell transistor MCb1 (BLk-1), the memory cell transistor MCb1 (BLk), and the memory cell transistor Mcb1 (BLk+1) are memory cell transistors MC in the same page (Page) connected to the same select word line SEL-WLb1 and controlled by the same select word line SEL-WLb1 and the same selected gate lines SGD1 and SGS1. As described above, FIG. 9 is a schematic diagram focusing on the memory string MSb and shows a plurality of memory cell transistors MC (MCb1 (BLk-1), MCb1 (BLk), Mcb1 (BLk+1) connected to the same select word line SEL-WLb1 in the memory string MSb, and a schematic diagram showing one memory cell transistor MC among the plurality of memory cell transistors MC connected to the same select word line SEL-WLb1.

In addition, a program target level of the memory cell transistor MCb1 (BLk-1) is a "G" level (program target "G"). A program target level of the memory cell transistor MCb1 (BLk) is an "Er" level (program target "Er"), and a program target level of the memory cell transistor MCb1 (BLk-1) is a "D" level (program target "D").

Further, the memory controller 2 transmits a signal (write operation signal) instructing a data write operation to the non-volatile semiconductor memory device. For example, when the non-volatile semiconductor memory device receives the write operation signal, the sequencer 15 controls the sense amplifier module 20, the row decoder 19, the voltage generation circuit 17, and the like based on the write operation signal via the logic control circuit 11, the input-output circuit 10, and the command register 14 to execute the write operation. For example, a voltage is supplied to the word line WL, the select gate line SGD, the select gate line SGS, the source line SL, the bit line BL, the control signal BLS, the control signal BLC, and the like under the control of the voltage generator 17, the sense amplifier module 20, and the row decoder 19 using the sequencer 15.

### [7-1-1. Example of Write Operation of Non-volatile Semiconductor Device in Comparative Example]

First, an example of a write operation of the non-volatile semiconductor device in the comparative example will be described with reference to FIG. 8 to FIG. 11.

### [7-1-1-1. Example of Write Operation Up to Time T0]

The write operation up to time T0 includes setting the state of the non-volatile semiconductor-memory device 1 to a standby state. For example, the standby state is a state in which the non-volatile semiconductor memory device 1 is waiting for data writing.

As shown in FIG. 8, up to the time T0, the voltage VSS is supplied to the select gate line SEL-SGD (SGD1), the non-select gate lines USEL-SGD (SGD0, SGD2, SGD3, ...), the select gate lines SGS (SGS0, SGS1, SGS3, ...), the select word line SEL-WLb1, the non-select word lines USEL-WL other than the select word line SEL-WLb1, the bit line Program BL, the bit line Inhibit BL, the channels of the memory cell transistors to be operated, the channels of the memory cell transistors not to be operated, and the control signals BLC.

As shown in FIG. 8, since the voltage VSS is supplied to each control line, each memory cell transistor MC is in the off-state.

### [7-1-1-2. Example of Write Operations of Time T0 to Time T1]

Next, write operations of time T0 to time T1 will be described. For example, the write operations of the time T0 to time T1 include supplying a voltage VSGPCH to the select gate line SEL-SGD and the non-select gate line USEL-SGD, and supplying a voltage VCHPCH to the select word line SEL-WLb1 and the non-select word line USEL-WL.

As shown in FIG. 8, in the time T0 to T1, the voltage VSGPCH is supplied to the select gate line SEL-SGD and the non-select gate line USEL-SGD, and the voltage VSGPCH is supplied to the select word line SEL-WLb1 and the non-select word line USEL-WL. Further, the voltage supplied to the control signal BLC gradually increases toward a voltage VDD+VTH. The select gate line SGS, the bit line Program BL, the bit line Inhibit BL, the channel of the memory cell transistor to be operated, and the channel of the memory cell transistor not to be operated are supplied with the voltage VSS, the same as up to the time T0.

Based on the voltages supplied to the control lines at the time T1, the select transistors ST1-k-1, ST1-k and ST1-k+1, the memory cell transistors MCb0 to MCb3, and the memory cell transistors MCa to MCa3 are changed to the on-state, and the select transistors ST2-k-1, ST2-k and ST2-k+1 are maintained in the off-state.

Consequently, in the time T1, the voltage VSS supplied to the bit line BLk-1 is supplied to the Channel (k-1) of each of the select transistor ST1-k-1 and the memory cell transistors MCb0 to MCb3 connected to the select transistor ST1-k-1, the voltage VSS supplied to the bit line BLk is supplied to the Channel (k) of each of the select transistor ST1-k and the memory cell transistors MCb0 to MCb3 connected to the select transistor ST1-k, and the voltage VSS supplied to the bit line BLk+1 is supplied to the Channel (k+1) of each of the select transistor ST1-k+1 and the memory cell transistors MCb0 to MCb3 connected to the select transistor ST1-k+1.

### [7-1-1-3. Example of Write Operations of Time T1 to Time T2]

Next, write operations of time T1 to time T2 will be described. The write operations of the time T1 to time T2 are operations of pre-charging the bit line Inhibit BL and the channel of the memory cell transistor not to be operated. For example, the write operations of the time T1 to time T2 include supplying a voltage VDD to the bit line Inhibit BL and supplying the voltage VDD to the channel of the memory cell transistor that is not to be operated and is connected to the bit line Inhibit BL.

As shown in FIG. 8, in the time T1 to T2, the control signal BLC is supplied with the voltage VDD+VTH. Similar to the time T1, the voltage VSGPCH is supplied to the select gate line SEL-SGD and the non-select gate line USEL-SGD, the voltage VSGPCH is supplied to the select word line SEL-WLb1 and the non-select word line USEL-WL, and the voltage VSS is supplied to the select gate line SGS.

Based on the voltages supplied to the respective control lines at the time T2, the select transistors ST1-k-1, ST1-k and ST1-k+1, the memory cell transistors MCb0 to MCb3, and the memory cell transistors MCa0 to MCa3 are maintained in the on-state, and the select transistors ST2-k-1, ST2-k and ST2-k+1 are maintained in the off-state. Further, when the voltage VDD+VTH is supplied to the control signal BLC, the transistor 122 of the sense amplifier part SAU connected to the bit line Program BL is changed to the on-state, the voltage VSS is supplied to the bit line Program BL, and the voltage VSS is supplied to the channel of the memory cell transistor to be operated. Further, when the voltage VDD+VTH is supplied to the control signal BLC, the transistor 122 of the sense amplifier part SAU connected to the bit line Inhibit BL is changed to the on-state, the voltage VDD is supplied to the bit line Inhibit BL, and the voltage VDD is supplied to the channel of the memory cell transistor not to be operated. The plurality of bit lines Inhibit BL are supplied with the voltage VDD at the same timing.

### [7-1-1-4. Example of Write Operations of Time T2 to Time T3]

Next, write operations of time T2 to time T3 will be described. As shown in FIG. 8, in the time T2 to the time T3, the voltage supplied to the select gate line SEL-SGD and the non-select gate line USEL-SGD is changed from the voltage VSGPCH to the voltage VSS, and the voltage supplied to the select word line SEL-WLb1 and the non-select word line USEL-WL is changed from the voltage VSGPCH to the voltage VSS. Further, similar to the time T2, the voltage VSS is supplied to the select gate line SGS, the bit line Program BL, the channel of the memory cell transistor to be operated, and the control signal BLC. The voltage VDD is supplied to the bit line Inhibit BL and the memory cell transistor not to be operated. Therefore, since the voltage VSS is supplied to each control line, each memory cell transistor MC is in the off-state.

### [7-1-1-5. Example of Write Operations of Time T3 to Time T4]

Next, write operations of time T3 to time T4 will be described. The write operations of the time T3 to the time T4 include the channel of the memory cell transistor not to be operated being boosted from a state in which the voltage VDD is supplied to a state in which a voltage VCHA is supplied.

As shown in FIG. 8, in the time T3 to T4, the select gate line SEL-SGD is changed from a state where the voltage VSS is supplied to a state where the voltage VSG is supplied, the non-select gate line USEL-SGD is supplied with the voltage VSS, the select word line SEL-WLb1 and the non-select word line USEL-WL are changed from a state where the voltage VSS is supplied to a state where a voltage VPASS is supplied, and the control signal BLC is changed from a state where the voltage VSS is supplied to a state where a voltage VBLC is supplied. Further, similar to the time T3, the voltage VSS is supplied to the select gate line SGS, the bit line Program BL, and the channel of the memory cell transistor to be operated, and the voltage VDD is supplied to the bit line Inhibit BL and the channel of the memory cell transistor not to be operated.

The voltage VSS supplied to the bit line Program BL is sufficiently lower than the voltage VSG supplied to the select gate line SEL-SGD. Therefore, the select transistor ST1 connected to the bit line Program BL is changed to the on-state, and the voltage VSS is supplied to the channel of the memory cell transistor to be operated. The voltage VDD supplied to the bit line Inhibit BL is sufficiently higher than the voltage VSG supplied to the select gate line SEL-SGD. Therefore, since the voltage VSG supplied to the gate of the select transistor ST1 connected to the bit line Inhibit BL is relatively low, the select transistor ST1 is changed to the off-state. In addition, the select word line WLb1 and the unselect word line WL are supplied with the voltage VPASS, and the memory cell transistors MC of the respective layers are in the on-state.

Therefore, the bit line Inhibit BL and the channel of the memory cell transistor not to be operated are electrically disconnected. Consequently, capacitive coupling between the channel of the memory cell transistor not to be operated and the non-select word line USEL-WL boosts the channel of the memory cell transistor not to be operated from a state where the voltage VDD is supplied to a state where the voltage VCHA is supplied.

### [7-1-1-6. Example of Write Operations of Time T4 to Time T5]

Next, write operations of the time T4 to T5 will be described. The write operations of the time T4 to time T5 are operations of writing threshold voltages corresponding to the program target level to the memory cell transistor to be operated. As shown in FIG. 8, in the time T4 to the time T5, the select gate line SEL-SGD (SGD1) is supplied with the voltage VSG, the bit line Program BL is supplied with the voltage VSS, and the select transistor ST1 connected to the bit line Program BL is maintained in the on-state. Further, the bit line Inhibit BL is supplied with the voltage VDD, and the select transistor ST1 connected to the bit line Inhibit BL is changed to the off-state. The select word line SEL-WLb1 is changed from a state where the voltage VPASS is supplied to a state where a voltage VPGM is supplied, and the memory cell transistor MC electrically connected to the select word line SEL-WLb1 is changed to the on-state. Similar to the time T4, the voltage supplied to the channel of the memory cell transistor to be operated maintains the voltage VSS, the voltage supplied to the channel of the memory cell transistor not to be operated maintains the voltage VCHA, the select gate line SGS is supplied with the voltage VSS, the select transistor ST2 is maintained in the off-state, and the control signal BLC maintains a state where the voltage VBLC is supplied.

For example, the select word line SEL-WLb1 is supplied with the voltage VPGM, the memory cell transistor to be operated is changed to the on-state, and the bit line Program BL is supplied with the voltage corresponding to the program target level from a state where the voltage VSS is supplied. For example, the voltage VPGM is a voltage that is sufficiently higher than the voltage corresponding to the program target level. Therefore, an electric field due to a potential difference between the voltage VSS of the channel and the voltage VPGM of the select word line SEL-WLb1 is applied to the memory cell transistor to be operated, and electrons are injected into the charge storage layer of the memory cell transistor. As a result, a program corresponding to the program target level is performed on the memory cell transistor to be operated, and the threshold voltage of the memory cell transistor rises. In addition, the voltage VPGM may be referred to as a "write voltage".

The channel of the memory cell transistor that is not to be operated and is connected to the bit line Inhibit BL maintains a state where the voltage VCHA is supplied. Therefore, an electric field due to a potential difference between the voltage VCHA of the channel and the voltage VPGM of the select word line SEL-WLb1 is applied to the memory cell transistor not to be operated. If the potential difference between the voltage VCHA and the voltage VPGM is sufficiently small, no electrons are injected (or only a small amount of electrons are injected) into the charge storage layer of the memory cell transistor not to be operated. As a result, the memory cell transistor not to be operated is not programmed, and the threshold voltage of the memory cell transistor does not increase (or only slightly increases).

### [7-1-1-7. Specific Example of Writing Operation of Non-volatile Semiconductor Device in Comparative Example]

First, with reference to FIG. 8 and FIG. 10, a specific example in a first loop to a fourth loop in the program loop shown in FIG. 7 will be described.

When the voltage VPGM is supplied to the select word line SEL-WLb1 shown in FIG. 8, the voltage VSS is supplied from the bit line BLk-1 via the select transistor ST1-k-1 to the Channel (k-1), and the voltage VSS is supplied from the bit line BLk+1 via the select transistor ST1-k+1 to Channel (k+1). Consequently, the threshold voltages of the memory cell transistor MCb1 (BLk-1) of the k-1 layer and the memory cell transistor MCb1 (BLk+1) of the k+1 layer increase.

On the other hand, since the bit line BLk is supplied with the voltage VDD and the select transistor ST1-k connected to the bit line BLk is cut off, the Channel (k) is in a floating state.

Consequently, for example, in a state in which the voltage VPASS is supplied to the select word line SEL-WLb1, the Channel (k) is boosted from a state in which the voltage VDD is supplied to a state in which a voltage VCH1 is supplied. Therefore, even if the voltage supplied to the select word line SEL-WLb1 rises from the voltage VPASS to the voltage VPGM, a potential difference between the voltage supplied to the select word line SEL-WLb1 and the voltage supplied to Channel (k) does not increase. Therefore, the threshold voltage of the memory cell transistor MCb1 (BLk) including a part of the Channel (k) does not increase.

Next, with reference to FIG. 8 and FIG. 11, a specific example of a fifth loop to a seventh loop in the program loop shown in FIG. 7 will be described. In the fifth loop to the seventh program loop, although the memory cell transistor having the "D" level as the program target level is not subject to the operation, the memory cell transistor having the "G" level as the program target level is subject to the operation. Therefore, the select word line SEL-WLb1 is supplied with the voltage VPGM.

That is, as shown in the bit line Inhibit BL of FIG. 8 and the channel of the memory cell transistor not to be operated, the bit line BLk+1 and the Channel (k+1) connected to the bit line BLk+1 is supplied with the voltage VDD in the same manner as the bit line BLk and the Channel (k) connected to the bit line BLk. Consequently, since the select transistor ST1-k+1 is cut off, the Channel (k+1) is in a floating state. Thus, similar to the Channel(k), the Channel(k+1) is boosted. Consequently, with the voltage VPGM being supplied to the select word line SEL-WLb1, the Channel (k+1) is boosted from a state in which the voltage VDD is supplied (see the channel of the memory cell transistor not to be operated of FIG. 8) to a state in which a voltage VCH2 is supplied (see the Channel (k+1) of FIG. 11).

Here, the Channel (k) is boosted from a state where the voltage VDD is supplied to a state where the voltage VCH1 is supplied by the program target of the memory cell transistor MCb1 (BLk) including a part of the Channel (k) being at the "Er" level and the voltage VPGM being supplied to the select word line SEL-WLb1. In addition, since the threshold voltage of the memory cell transistor MCb1 (BLk+1) including a part of the Channel (k+1) is raised to the "D" level higher than the "Er" level, as described above, the voltage supplied to the Channel (k+1) becomes a state where the voltage VCH2 is supplied from a state where the voltage VDD is supplied due to the voltage VPGM being supplied to the select word line SEL-WLb1. At this time, since the Channel (k) is in the floating state, for example, the Channel (k) is further boosted from the state in which the voltage VCH1 is supplied to a state in which a voltage VCH3 higher than the voltage VCH1 is supplied, due to an effect of the voltage VCH2 supplied to the Channel (k+1).

Here, the larger the potential difference between the voltage supplied to the select word line SEL-WLb1 and the voltage supplied to the Channel (k), the more likely the unintended increase in the threshold voltage occurs in the memory cell transistor MCb1 (BLk). Although the state of the Channel (k) described above is a state in which the voltage VCH3 is supplied, a potential difference between the voltage VPGM supplied to the select word line SEL-WLb1 and the voltage VCH3 is still large, and is a potential difference in which an unintended increase in the threshold voltage in the memory cell transistor MCb1 (BLk) can occur. Therefore, for example, a memory cell transistor in which a threshold voltage having a low program target level is written is likely to have an unintended increase in the threshold voltage in a program loop in the second half, such as a fifth loop to a seventh loop. For example, the fact that an unintended increase in the threshold voltage is likely to occur is expressed as "program disturbance tends to occur".

Therefore, the write operation of the non-volatile semiconductor device in the comparative example tends to cause an unintended increase in the threshold voltage (program disturbance tends to occur).

### [7-1-2. Example of Write Operation in Memory Cell Array 18 of Non-volatile Semiconductor Memory Device 1]

Next, an example of a write operation in the memory cell array 18 of the non-volatile semiconductor memory device 1 will be described with reference to FIG. 9, FIG. 12, and FIG. 13. A timing chart shown in FIG. 12 corresponds to the timing chart of the fifth to seventh loops in the program loop shown in FIG. 7.

In an example of the write operation in the memory cell array 18 of the non-volatile semiconductor memory device 1, a selected memory cell transistor MC to be subjected to the write operation is a memory cell transistor MC connected to the bit line BLk-1, the source line SL1, and the select word line SEL-WLb1. The memory cell transistor MC is the memory cell transistor MCb1 (BLk-1) shown in FIG. 3 or FIG. 9, and the memory cell transistor MCb1 (BLk-1) includes a part of the k-1 layer semiconducting layer 31 (Channel (k-1)). The bit line BLk-1 is the bit line Program BL.

Further, in an example of the write operation in the memory cell array 18 of the non-volatile semiconductor memory device 1, the non-selected memory cell transistors MC which are not subject to the write operation are the bit line BLk, the source line SL1, and the memory cell transistors MCb1 (BLk) connected to the select word line SEL-WLb1, and the memory cell transistors Mcb1 (BLk+1) connected to the bit line BLk+1, the source line SL1, and the select word line SEL-WLb1. As shown in FIG. 3 or FIG. 9, the memory cell transistor MCb1 (BLk) includes a part of the k-layer semiconductor layer 31 (Channel (k)), and the memory cell transistor Mcb1 (BLk+1) includes a part of the k+1-layer semiconductor layer 31 (Channel (k+1)). In addition, the bit line BLk is a bit line Inhibit BL (BLk) and the bit line BLk+1 is a bit line Inhibit BL (BLk+1).

In the write operation in the memory cell array 18 of the non-volatile semiconductor memory device 1, a time change of the voltage at each time of the select gate line SEL-SGD (SGD1), the non-select gate lines USEL-SGD (SGD0, SGD2, SGD3, ...), the select gate lines SGS (SGS0, SGS1, SGS2, SGS3, ...), the select word line SEL-WLb1, the non-select word lines USEL-WL other than the select word line SEL-WLb1, and the control signal BLC is the same as a time change of the voltage at each time of the non-select word line SEL-SGD (SGD1), the non-select gate lines USEL-SGD (SGD0, SGD2, SGD3, ...), the select word line SEL-WLb1, and the non-select word lines USEL-WL other than the select word line SEL-WLb1, and the control signal BLC. Therefore, in the description of the write operation in the memory cell array 18 of the non-volatile semiconductor memory device 1, the description of the temporal change of the voltages at the respective times of the select gate line SEL-SGD, the non-select gate line USEL-SGD, the select gate line SGS, and the non-select word lines USEL-WL other than the select word line SEL-WLb1 and the select word line SEL-WLb1 is omitted.

### [7-1-2-1. Example of Write Operation Up to Time T0]

First, a write operation up to time T0 will be described.

As shown in FIG. 12, until the time T0, a bit line ProgramBLk-1, a bit line Inhibit BLk, and a bit line Inhibit BLk+1 are supplied with the voltage VSS. The bit line ProgramBLk-1 may be referred to as a "second bit line", the bit line Inhibit BLk may be referred to as a "first bit line", and the bit line Inhibit BLk+1 may be referred to as a "third bit line".

In addition, as described above, the channel layer of the memory cell transistor MC that is the target of the write operation is the Channel (k-1), and the channel layer of the memory cell transistor MC that is not the target of the write operation is the Channel (k) or the Channel (k+1). The Channel (k-1), the Channel (k), and the Channel (k+1) are supplied with the voltage VSS. In a data latch DL shown in FIG. 12, data (threshold voltage) logically calculated using the latch circuit SDL, ADL, BDL, CDL, or XDL in the sense amplifier part SAU is represented. For example, the logical operated data may be stored in either the latch circuit SDL, ADL, BDL, CDL or XDL. For example, in the data latch DL, data is not stored in the time T0.

As shown in FIG. 12, since the voltage VSS is supplied to each control line, each memory cell transistor MC is in the off-state.

### [7-1-2-2. Example of Write Operations of Time T0 to Time T1]

Next, write operations of time T0 to time T1 will be described.

As shown in FIG. 12, in the time T0 to the time T1, the voltage supplied to the control signal BLC gradually increases toward the voltage VDD+VTH (eighth voltage). The select gate line SGS (SGS1), the bit line ProgramBLk-1, the bit line Inhibit BLk, the bit line Inhibit BLk+1, the Channel (k-1), the Channel (k), and the Channel (k+1) are supplied with the voltage VSS the same as up to the time T0. The same as the time T0, no data is stored in the data latch DL.

Here, the voltage VSGPCH may be a voltage greater than the voltage VCHPCH and may be a voltage having the same magnitude as the voltage VCHPCH. In addition, for example, the voltage VCHPCH is greater than the voltage VSS. In addition, the voltage VDD is greater than the voltage VSS and may be the same or substantially the same as the voltage VCHPCH.

Based on the voltages supplied to each control line at the time T1, the select transistors ST1-k-1, ST1-k and ST1-k+1, the memory cell transistors MCb0 to MCb3, and the memory cell transistors MCa0 to MCa3 are changed to the on-state, and the select transistors ST2-k-1, ST2-k, and ST2-k+1 are maintained in the off-state.

Consequently, in the time T1, the voltage VSS supplied to the bit line BLk-1 is supplied to the select transistor ST1-k-1 and the Channel (k-1) (second channel) of each of the memory cell transistors MCb0 to MCb3 (second memory cell) connected to the select transistor ST1-k-1, the voltage VSS supplied to the bit line BLk is supplied to the select transistor ST1-k and the Channel (k) (first channel) of each of the memory cell transistors MCb0 to MCb3 (first memory cell) connected to the select transistor ST1-k, and the voltage VSS supplied to the bit line BLk+1 is supplied to the select transistor ST1-k+1 and the Channel (k+1) (third channel) of each of the memory cell transistors MCb0 to MCb3 (third memory cell) connected to the select transistor ST1-k+1.

### [7-1-2-3. Example of Write Operations of Time T1 to Time T2]

Next, the write operations of the time T1 to time T2 will be described. The write operations of the time T1 to the time T2 are operations of pre-charging the bit line Inhibit BL (BLk), the bit line Inhibit BL (BLk+1), the Channel (k), and the Channel (k+1). For example, the write operations of the time T1 to the time T2 include supplying the voltage VDD to the bit line Inhibit BL (BLk), then supplying the voltage VDD to the bit line Inhibit BL (BLk+1) and raising the voltage supplied to the bit line Inhibit BL (BLk) from the voltage VDD to a voltage VDD+dv (third voltage). Further, the write operations of the time T1 to the time T2 include supplying the voltage VDD to the bit line Inhibit BL (BLk) and supplying the voltage VDD to the Channel (k) of the memory cell transistor MCb1 (BLk) connected to the bit line Inhibit BL (BLk), then supplying the voltage VDD to the bit line Inhibit BL (BLk+1) and raising the voltage supplied to the Channel (k) from the voltage VDD to the voltage VDD+dv.

As shown in FIG. 12, in the time T1 to T2, the control signal BLC is supplied with the voltage VDD+VTH. Similar to the time T1, the select gate line SGS (SGS1), the bit line ProgramBLk-1, and the Channel (k-1) are supplied with the voltage VSS.

Based on the voltages supplied to the respective control lines at the time T2, the select transistors ST1-k-1, ST1-k, and ST1-k+1, the memory cell transistors MCb0 to MCb3, and the memory cell transistors MCa0 to MCa3 are maintained in the on-state, and the select transistors ST2-k-1, ST2-k, and ST2-k+1 are maintained in the off-state. Further, when the voltage VDD+VTH is supplied to the control signal BLC, the transistor 122 of the sense amplifier part SAU connected to the bit line Inhibit BLk-1 is changed to the on-state, the voltage VSS is supplied to the bit line ProgramBLk-1, the voltage VSS is supplied to the select transistor ST1-k-1, and the Channel (k-1) (first channel) of each of the memory cell transistors MCb0 to MCb3 (first memory cell) connected to the select transistor ST1-k-1. Further, when the voltage VDD+VTH is supplied to the control signal BLC, the transistor 122 of the sense amplifier part Inhibit BL (BLk) connected to the bit line SAU is changed to the on-state, the voltage VDD is supplied to the bit line Inhibit BL (BLk), and the voltage VDD is supplied to the select transistor ST1-k and the Channel (k) of each of the memory cell transistors MCb0 to MCb3 connected to the select transistor ST1-k. Further, when the voltage VDD+VTH is supplied to the control signal BLC, the transistor 122 of the sense amplifier part SAU connected to the bit line Inhibit BL (BLk+1) is changed to the on-state, the voltage VDD is supplied to the bit line Inhibit BL (BLk+1), and the voltage VDD is supplied to the select transistor ST1-k+1 and the Channel (k+1) (third channel) of each of the memory cell transistors MCb0 to MCb3 (third memory cell) connected to the select transistor ST1-k+1.

When the voltage VDD is supplied to the bit line Inhibit BL (BLk) and the Channel (k), the memory cell transistor MCb1 (BLk) is in a floating state. In this condition, when the voltage VDD is supplied to the bit line (BLk+1) and Channel (k+1), capacitive coupling between the bit line Inhibit BL (BLk+1) (Channel (k+1)) and the bit line Inhibit BL (BLk) (Channel (k)) causes the voltage supplied to the bit line Inhibit BL (BLk) and the voltage supplied to the Channel (k) to increase from the voltage VDD to the voltage VDD+dv. In addition, at the timing when the voltage VDD is supplied to the Channel (k), the data latch DL indicates a threshold voltage at which the program target level logically calculated using the latch circuit SDL, ADL, BDL, CDL, or XDL in the sense amplifier part SAU is at the "Er" level. The threshold voltage with the program target level of "Er" may be stored in either the latch circuit SDL, ADL, BDL, CDL, or XDL. Further, at the timing when the voltage VDD is supplied to the Channel (k+1), the data latch DL indicates a threshold voltage at a level from the "A" level to the "F" level, which are program target levels logically calculated using the latch circuit SDL, ADL, BDL, CDL, or XDL in the sense amplifier part SAU. The threshold voltage with program target levels of the "A" level to the "F" level may be stored in either the latch circuit SDL, ADL, BDL, CDL, or XDL.

In addition, after the voltage VDD is supplied to the Channel (k) and the voltage VDD is supplied to the Channel (k+1), the voltage VSS is supplied to the control signal BLC.

### [7-1-2-4. Example of Write Operations of Time T2 to Time T3]

Next, write operations of the time T2 to time T3 will be described. As shown in FIG. 12, in the time T2 to the time T3, similar to the time T2, the select gate line SGS (SGS1), the bit line ProgramBLk-1, the Channel (k-1), and the control signal BLC are supplied with the voltage VSS, the bit line Inhibit BLk and the Channel (k) are supplied with the voltage VDD+dv, and the bit line Inhibit BLk+1 and the Channel (k+1) are supplied with the voltage VDD. Further, similar to the time T2, in the data latch DL, the threshold voltages of "A" level to "F" level are indicated as the program target levels logically calculated using the latch circuit SDL, ADL, BDL, CDL, or XDL in the sense amplifier part SAU, and, for example, the threshold voltages of "A" level to "F" level are stored in either the latch circuit SDL, ADL, BDL, CDL, or XDL. Therefore, since the voltage VSS is supplied to each control line, each memory cell transistor MC is in the off-state.

### [7-1-2-5. Example of Write Operations of Time T3 to Time T4]

Next, write operations of the time T3 to time T4 will be described. The write operations of the time T3 to the time T4 include the Channel (k+1) of the unselected memory cell transistor MC (Mcb1 (BLk+1)) being boosted from a state where the voltage VDD is supplied to a state where a voltage VCHB (fifth voltage) is supplied, and the Channel (k) of the unselected memory cell transistor MC (MCb1 (BLk)) being boosted from a state where the voltage VDD+dV is supplied to a state where a voltage VCHC (sixth voltage) is supplied.

As shown in FIG. 12, in the time T3 to the time T4, the select gate line SEL-SGD (SGD1) is changed from a state where the voltage VSS is supplied to a state where the voltage VSG is supplied, the non-select gate line USEL-SGD (SGD1) is supplied with the voltage VSS, the select word line SEL-WLb1 and the non-select word line USEL-WL are changed from a state where the voltage VSS is supplied to a state where the voltage VPASS (fourth voltage) is supplied, and the control signal BLC is changed from a state where the voltage VSS is supplied to a state where the voltage VBLC is supplied. Further, similar to the time T3, the voltage VSS is supplied to the select gate line SGS (SGS1), the bit line ProgramBLk-1, the Channel (k-1), and the control signal BLC, the voltage VDD+dv is supplied to the bit line Inhibit BLk, and the voltage VDD is supplied to the bit line Inhibit BLk+1. Further, similar to the time T2, the bit line ProgramBLk-1 is supplied with the voltage VSS. In the data latch DL, the threshold voltages of "A" level to "F" level are indicated as the program target levels logically calculated using the latch circuits SDL, ADL, BDL, CDL or XDL in the sense amplifier part SAU. For example, the threshold voltages having program target levels of "A" level to "F" level are stored in either the latch circuit SDL, ADL, BDL, CDL, or XDL.

The voltage VSS supplied to the bit line ProgramBLk-1 is sufficiently lower than the voltage VSG supplied to the select gate line SEL-SGD. Therefore, the select transistor ST1-k-1 connected to the bit-line ProgramBLk-1 is changed to the on-state, and the voltage VSS is supplied to the Channel (k-1). The non-select gate line SGD (SGD1) is supplied with the voltage VSS and the bit line Inhibit BLk+1 is supplied with the voltage VDD. The non-select gate line SGD (SGD1) is supplied with the voltage VSS, and the bit line Inhibit BLk is supplied with the voltage VDD+dV. The voltage VDD supplied to the bit line Inhibit BLk+1 and the voltage VDD+dV supplied to the bit line Inhibit BLk are sufficiently higher than the voltage VSG supplied to the select gate line SEL-SGD. Therefore, since the voltage VDD supplied to the gate of the select transistor ST1-k+1 connected to the bit line Inhibit BLk+1 and the voltage VSG supplied to the gate of the select transistor ST1-k connected to the bit line Inhibit BLk are relatively low, the select transistor ST1-k +1 and the select transistor ST1-k are changed to the off-state. Further, the select word line WLb1 and the non-select word line WL are supplied with the voltage VPASS, and the memory cell transistors MC of the respective layers are in the on-state.

Therefore, the bit line Inhibit BLk+1 and the Channel (k+1) are electrically disconnected, and the bit line Inhibit BLk and the Channel (k) are electrically disconnected. Consequently, capacitive coupling between the Channel (k+1) and the non-select word line USEL-WL boosts the Channel (k+1) from a state where the voltage VDD is supplied to a state where the voltage VCHB is supplied, and capacitive coupling between the Channel (k) and the Channel (k+1) and the non-select word line USEL-WL boosts the Channel (k) from a state where the voltage VDD+dV is supplied to a state where the voltage VCHC is supplied.

For example, voltage VSG is less than voltage VSGPCH, the voltage VPASS (fourth voltage) is greater than voltage VCHPCH, the voltage VCHC is greater than the voltage VCHB, and voltage VCHB and the voltage VCHC are greater than the voltage VDD and the voltage VDD+dV.

As described with reference to FIG. 8, FIG. 10, and FIG. 11 in "7-1-1. Example of Write Operation of Non-volatile Semiconductor Device in Comparative Example", in the time T1 to T4, the non-volatile semiconductor memory device in the comparative example includes the voltage VDD being supplied to the plurality of bit lines Inhibit BL (BLk, BLk+1 in FIG. 12) at the same timing, and includes the voltage supplied to the Channel (k) being changed from the voltage VCH1 to the voltage VCH3 when the voltage supplied to the Channel (k+1) becomes the voltage VCH2. Consequently, a potential difference between the voltage VPGM and the voltage VCH3 supplied to the select word line SEL-WLb1 is still large, and the non-volatile semiconductor memory device in the comparative example tends to have an unintended increase in the threshold voltage (program disturbance tends to occur). Therefore, for example, in the case of using the non-volatile semiconductor memory device in the comparative example, a distribution width of the threshold becomes wider and a distribution width of the adjacent levels becomes closer, so that the threshold voltage distribution shown in FIG. 7 deteriorates.

On the other hand, in the non-volatile semiconductor memory device 1, the voltage VDD is supplied to the bit line Inhibit BLk, the memory cell transistor MC (memory cell transistor MCb1 (BLk)) including a part of the Channel (k) connected to the bit line Inhibit BLk is in the floating state and the voltage VDD is supplied to the bit line Inhibit BLk+1. As a result, the non-volatile semiconductor memory device 1 can increase the voltage supplied to the Channel (k) to the voltage VDD+dV by using the capacitive coupling between Channel (k) and Channel (k+1).

Therefore, in the subsequent operation, the non-volatile semiconductor memory device 1 can boost the Channel (k) of the memory cell transistor MCb1 (BLk) to the voltage VCHC greater than the voltage VCH1 to the voltage VCH3 in the comparative example. As a result, the non-volatile semiconductor memory device 1 is capable of suppressing interference between the Channel (k) and the Channel (k+1), suppressing rewriting of the threshold voltage stored in the memory cell transistor MCb1 (BLk), and suppressing deterioration of the threshold voltage distribution.

### [7-1-2-6. Example of Write Operations of Time T4 to Time T5]

Next, write operations of the time T4 to time T5 will be described. The write operations of the time T4 to the time T5 are operations of writing a threshold voltage having the program target level of "G" level to the selected memory cell transistor MCb1 (BLk-1). As shown in FIG. 12, the bit line ProgramBLk-1 is supplied with the voltage VSS and the select transistor ST1-k-1 maintains the on-state. The non-select gate line USEL-SGD (SGD1) is supplied with the voltage VSS, the bit line Inhibit BLk is supplied with the voltage VDD+dV, and the select transistor ST1-k is changed to the off-state. The non-select gate line USEL-SGD (SGD1) is supplied with the voltage VSS, the bit line Inhibit BLk+1 is supplied with the voltage VDD, and the select transistor ST1-k+1 is changed to the off-state. The select word line SEL-WLb1 is changed from a state where the voltage VPASS is supplied to a state where the voltage VPGM (the seventh voltage) is supplied, and the memory cell transistors MCb1 (BLk-1), MCb1 (BLk), and Mcb1 (BLk+1) are changed to the on-state. Similar to the time T4, the voltage supplied to the Channel (k-1) maintains the voltage VSS, the voltage supplied to the Channel (k) maintains the voltage VCHC, the voltage supplied to the Channel (k+1) maintains the voltage VCHB, the select gate line SGS (SGS1) maintains the voltage VSS, the select transistors ST2-k-1, ST2-k, and ST2-k+1 maintain the off-state, and the control signal BLC maintains a state where the voltage VBLC is supplied. Further, similar to the time T4, in the data latch DL, the threshold voltages of "A" level to "F" level are indicated as the program target levels logically calculated using the latch circuit SDL, ADL, BDL, CDL, or XDL in the sense amplifier part SAU, and, for example, the threshold voltages of "A" level to "F" level are stored in either the latch circuit SDL, ADL, BDL, CDL, or XDL.

For example, the voltage VPGM is greater than the voltage VPASS, the voltage VCHB, and the voltage VCHC. In addition, the voltage VCHB and the voltage VCHC are smaller than the voltage VPASS and larger than the voltage VSGPCH and the voltage VCHPCH.

In a state where the voltage VPGM is supplied to the select word line SEL-WLb1 and the memory cell transistor MCb1 is changed to the on-state, the voltage supplied to the bit line ProgramBLk-1 becomes a threshold voltage having the program target level of "G" level from the voltage VSS. The voltage VPGM is a voltage at which a program target level is sufficiently higher than the threshold voltage at the "G" level. Further, the voltage VPGM is sometimes referred to as a write voltage.

The Channel (k) of the memory cell transistor MCb1 (k) connected to the bit line Inhibit BLk maintains a state where the voltage VCHC is supplied. Therefore, the write operation of the non-volatile semiconductor memory device 1 can prevent the threshold voltage stored in the memory cell transistor MCb1 (k) (in this case, the threshold voltage having the program target level of "Er" level) from being rewritten.

In addition, a potential difference between the voltage VCHC (boost voltage) supplied to the Channel (k+1) of the memory cell transistor MCb1 (BLk+1) connected to the bit line Inhibit BLk+1 and the voltage VPGM (write voltage) supplied to the select word line WLb1 connected to the memory cell transistor MCb1 (BLk+1) is smaller than the potential difference between the voltage VCH3 and the voltage VPGM in the non-volatile semiconductor memory device of the comparative example. Therefore, in the write operation of the non-volatile semiconductor memory device 1, the potential difference between the boost voltage and the write voltage can be reduced. In the case where the boost voltage is small, since the potential difference between the boost voltage and the write voltage becomes large, the threshold voltage stored in the memory cell transistor MC may be rewritten. In this case, for example, as shown in FIG. 13, since a distribution width of the threshold voltage of the "Er" level is widened like a broken line, a distance between the distribution width of the threshold voltage of the "Er" level and a distribution width of the threshold voltage of the adjacent "A" level is narrowed, or the distribution width of the threshold voltage of the "Er" level may overlap the distribution width of the threshold voltage of the adjacent "A" level. On the other hand, in the write operation of the non-volatile semiconductor memory device 1, the boost voltage increases, and the potential difference between the boost voltage and the write voltage can be reduced. Therefore, as shown in FIG. 13, a distribution width of the threshold voltage of the "Er" level widened like a broken line can be narrowed as shown by a thick solid line, and a distribution width of the threshold voltages adjacent to each other can be moved away (a threshold window is enlarged). In addition, as in the case where the program target level is the "Er" level, even if the program target level is the "A" level, a distribution width of the threshold voltage of the "A" level can be narrowed such that the distribution width of the threshold voltage of the "A" level widened like a broken line is indicated by a thick solid line, and a distribution width of the threshold voltages adjacent to each other can be moved away (a threshold window is enlarged). Also, as in the case where the program target level widened like a broken line is the "Er" level, even if the program target level is the "B" level, a distribution width of the threshold voltage of the program target level is "B" level can be narrowed as indicated by a thick solid line, and a distribution width of the threshold voltages adjacent to each other can be moved away (a threshold window is enlarged). That is, the write operation of the non-volatile semiconductor memory device 1 can be applied to the entire page, and can suppress deterioration of the threshold voltage distribution when viewed in the entire page.

Further, the non-volatile semiconductor memory device 1 is assumed to have a certain degree of error. For example, in order to correct the error, the memory controller 2 of the memory system 3 includes ECC (Error Checking and Correcting). Generally, the higher an error rate, the more ECC resources are required. The non-volatile semiconductor memory device 1 can reduce the rate of errors in the page and improve accuracy of the operation. In addition, the non-volatile memory device 1 can reduce the rate of errors in the page, and can suppress the ECC resources corresponding to the reduction of the rate of errors in the page. As a result, the memory system 3 using the non-volatile semiconductor memory device 1 is a system capable of suppressing costs.

In addition, in the write operation of the non-volatile memory device 1, the operations up to the time T2 may be referred to as a "first operation", and the operations from the time T3 to the time T5 may be referred to as a "second operation".

### [Second Embodiment]

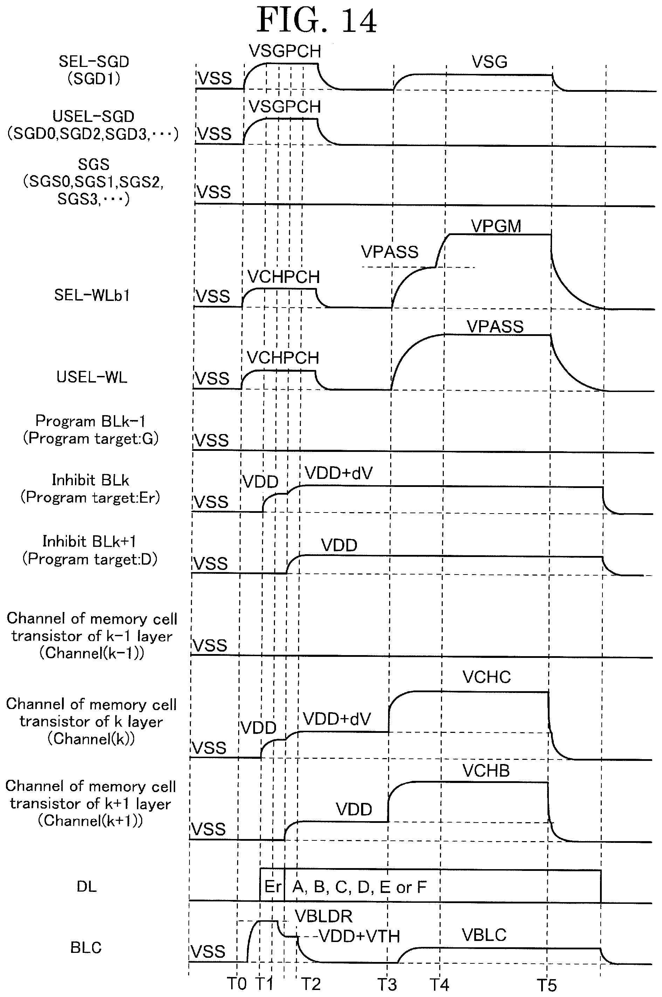

An example of a write operation in the memory cell array 18 of the non-volatile semiconductor memory device 1 according to a second embodiment will be described with reference to FIG. 14. FIG. 14 is a timing chart showing the write operation in the memory cell array 18 of the non-volatile semiconductor memory device 1 according to the second embodiment.

A timing chart according to the second embodiment includes the following configurations 1 to 3. The configurations 1 to 3 are different from the example of the write operation in the memory cell array 18 of the non-volatile semiconductor memory device 1 according to the first embodiment.
Configuration 1: In time T0 to time T1, the control signal BLC is changed from a state in which the voltage VSS is supplied to a state in which a voltage VBLDR (ninth voltage) is supplied. Configuration 2: In time T1 to time T2, the control signal BLC is changed from a state in which the voltage VBLDR is supplied to a state in which a voltage VDD+VTH is supplied. Configuration 3: The voltage VBLDR is a voltage greater than the voltage VDD+VTH.

The configurations other than the configurations 1 to 3 are the same as the example of the write operation in the memory cell array 18 of the non-volatile semiconductor memory device 1 according to the first embodiment. Therefore, description of the same configuration and function as the example of the write operation in the memory cell array 18 of the non-volatile semiconductor memory device 1 according to the first embodiment will be omitted.

The write operation in the memory cell array 18 of the non-volatile semiconductor memory device 1 according to the second embodiment has the same effects as the write operation in the memory cell array 18 of the non-volatile semiconductor memory device 1 according to the first embodiment.

### [Third Embodiment]

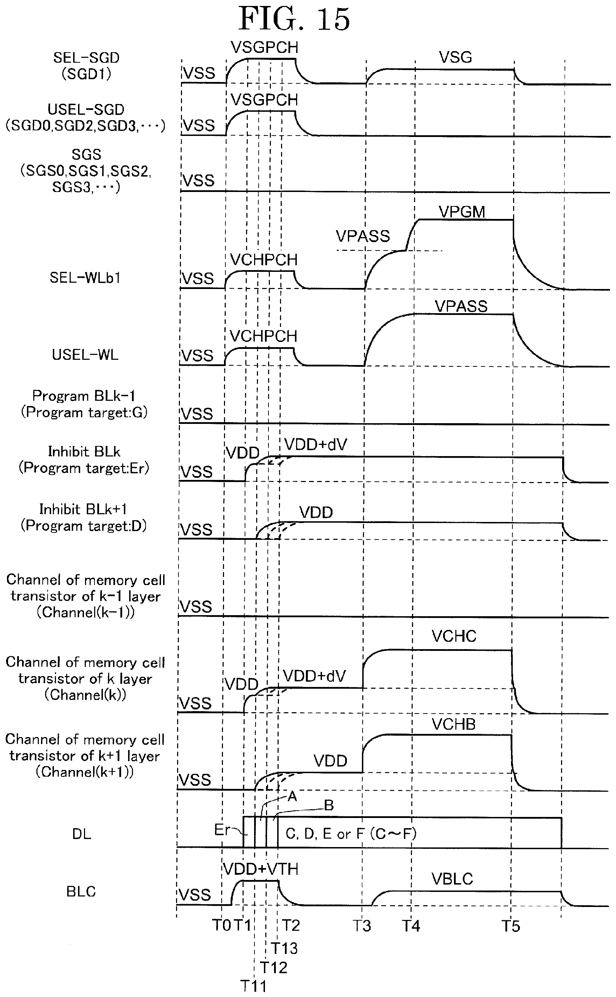

An example of a write operation in the memory cell array 18 of the non-volatile semiconductor memory device 1 according to a third embodiment will be described with reference to FIG. 15. FIG. 15 is a timing chart showing the write operation in the memory cell array 18 of the non-volatile semiconductor memory device 1 according to the third embodiment.

The timing chart according to the third embodiment includes a configuration 4 and a configuration 5 shown below. The configuration 4 and the configuration 5 are different from an example of the write operation in the memory cell array 18 of the non-volatile semiconductor memory device 1 according to the first embodiment.
Configuration 4: The voltage VDD is supplied to the bit line Inhibit BLk+1 and the Channel (k+1) at timings corresponding to a timing of the data (threshold voltage) to be computed by the data latch DL.
Configuration 5: The bit line Inhibit BLk and the Channel (k) are changed from a state where the voltage VDD is supplied to a state where the voltage VDD+dV is supplied at a timing when the voltage VDD is supplied to the bit line Inhibit BLk+1 and the Channel (k+1).

The configurations other than the configuration 4 and the configuration 5 are the same as the example of the write operation in the memory cell array 18 of the non-volatile semiconductor memory device 1 according to the first embodiment. Therefore, description of the same configuration and function as an example of the write operation in the memory cell array 18 of the non-volatile semiconductor memory device 1 according to the first embodiment will be omitted.

For example, as indicated by a solid-line waveform in FIG. 15, at a timing at which the threshold voltage having the program target level of "A" level is calculated and processed in the data latch DL in time T11, and the bit line Inhibit BLk+1 and the Channel (k+1) are changed from a state in which the voltage VDD is supplied to a state in which the voltage VDD+dV is supplied. Further, at the timing when the voltage VDD is supplied to the bit line Inhibit BLk+1 and the Channel (k+1), the bit lines Inhibit BLk and the Channel (k) are changed from the state where the voltage VDD is supplied to the state where the voltage VDD+dV is supplied.

Further, for example, as indicated by the broken-line waveform in FIG. 15, at a timing at which the threshold voltage having the program target level of "B" is calculated and processed in the data latch DL in time T12 following the time T11, the bit lines Inhibit BLk+1 and the Channel (k+1) are changed from a state in which the voltage VDD is supplied to a state in which the voltage VDD+dV is supplied. Further, at the timing when the voltage VDD is supplied to the bit line Inhibit BLk+1 and the Channel (k+1), the bit line Inhibit BLk and the Channel (k) are changed from the state where the voltage VDD is supplied to the state where the voltage VDD+dV is supplied.

Further, for example, as indicated by the broken-line waveform in FIG. 15, at a timing at which the threshold voltages at the program target level of "C" level to "F" level are calculated and processed in the data latch DL in time T13 following the time T12, the bit line Inhibit BLk+1 and the Channel (k+1) are changed from a state where the voltage VDD is supplied to a state where the voltage VDD+dV is supplied. Further, at the timing when the voltage VDD is supplied to the bit line Inhibit BL (BLk+1) and the Channel (k+1), the bit line Inhibit BL (BLk) and the Channel (k) are changed from the state where the voltage VDD is supplied to the state where the voltage VDD+dV is supplied.

In the non-volatile semiconductor memory device 1, the threshold voltage is written to the memory cell transistor MC at a different rate depending on the level of the threshold voltage ("Er" level to "G" level). The non-volatile semiconductor memory device 1 according to the third embodiment can change the timing at which the Channel (for example, the Channel (k)) one layer below the Channel (for example, the Channel (k-1) included in the memory cell transistor to be written along the Z direction is changed from the state in which the voltage VDD is supplied to the state where the voltage VDD+dV is supplied in accordance with the level of the threshold voltage ("Er" level to "G" level). As a consequence, the non-volatile semiconductor memory device 1 according to the third embodiment can optimize a timing of boosting the lower Channel along the Z direction with respect to the Channel included in the memory cell transistor to be written, in accordance with the level of the threshold voltage ("Er" level to "G" level).

### [Other Embodiments]

Each part described as a configuration included in the memory system 3 in the first to third embodiments described above may be realized by either hardware or software, or may be realized by a combination of hardware and software.

In the above embodiments, in the case where the terms "identical" and "matching" are used, "identical" and "matching" may include cases where there is a margin of error within the range of design.

In addition, in the case where a certain voltage is expressed as being applied or supplied, the present disclosure includes both a control of applying or supplying the voltage and an actual application or supply of the voltage. Further, applying or supplying the certain voltage may include, for example, applying or supplying a voltage of 0 V.

As used herein, "connection" refers to an electrical connection, and does not exclude, for example, the intervention of another element therebetween.

Various embodiments are in accordance with the following numbered clauses.

Clause 1. A non-volatile semiconductor memory device comprising:
a plurality of first memory cell transistors (Mcb1(BLk)), a plurality of second memory cell transistors (Mcb1(BLk-1)), and a plurality of third memory cell transistors (Mcb1(BLk)+1), each of which can be set to a threshold voltage of 2ⁿ (n is an integer equal to or greater than 2) or more different levels;
a first bit line (BLk) extending in a first direction (X direction);
a second bit line (BLk-1) and a third bit line parallel to the first bit line (BLk+1);
a source line (SL1)arranged on a side opposite to the first bit line with respect to the first direction and extending along with a second direction (Y direction) intersecting the first direction;
a first semiconductor layer (Channel(k)) extending in the first direction and including the plurality of first memory cell transistors electrically connected between the first bit line and the source line;
a second semiconductor layer (Channel(k-1)) including the plurality of second memory cell transistors connected between the second bit line and the source line and stacked with the first semiconductor layer along a third direction intersecting both the first direction and the second direction;
a third semiconductor layer (Channel(k+1)) including the plurality of third memory cell transistors connected between the third bit line and the source line and stacked on a side of the first semiconductor layer opposite to a side on which the second semiconductor layer is stacked along the third direction; and
a control circuit (15) configured to control each of the plurality of the first memory cell transistors, each of the plurality of the second memory cell transistors, and each of the plurality of the third memory cell transistors to execute a write operation including a first operation and a second operation,
wherein
when performing the write operation for writing data to one second memory cell transistor among the plurality of the second memory cell transistors, the control circuit performs controls so that it is possible to perform the first operation of supplying a first voltage (VSS) as a reference voltage to the second bit line and a second channel of the plurality of the second memory cell transistors, supplying a second voltage (VDD) greater than the first voltage to the first bit line and a first channel of the plurality of the first memory cell transistors, and then supplying the second voltage to the third bit line and a third channel of the plurality of the third memory cell transistors, and boosting the voltage supplied to the first channel to a third voltage (VDD+dV) greater than the second voltage.

Clause 2. The non-volatile semiconductor memory device according to Clause 1, further comprising a word line (WLb1) parallel to the source line along the second direction; wherein
the word line is connected to one second memory cell transistor, one first memory cell transistor among the plurality of first memory cell transistors, and one third memory cell transistor among the plurality of third memory cell transistors, and one first memory cell transistor is programmed with a threshold voltage of the lowest level ("Er" level) among the 2ⁿ or more different levels.

Clause 3. The non-volatile semiconductor memory device according to Clause 2, further comprising:
a drain side select gate line (SGD) intersecting the first bit line, the second bit line, and the third bit line;
a source side select gate line (SGS) parallel to the source line;
a first drain side select transistor (ST1-K-1) electrically connected between the first bit line and the plurality of first memory cell transistors;
a first source side select transistor (ST2-K-1) electrically connected between the plurality of first memory cell transistors and the source line;
a second drain side select transistor (ST1-K) electrically connected between the second bit line and the plurality of second memory cell transistors;
a second source side select transistor (ST2-K) electrically connected between the plurality of second memory cell transistors and the source line;
a third drain side select transistor (ST1-K+1) electrically connected between the third bit line and the plurality of third memory cell transistors; and
a third source side select transistor (ST2-K+1) electrically connected between the plurality of third memory cell transistors and the source line;
wherein
the drain side select gate line is connected to the first drain side select transistor, the second drain side select transistor, and the third drain side select transistor, and
the source side select gate line is connected to the first source side select transistor, the second source side select transistor, and the third source side select transistor.

Clause 4. The semiconductor memory device according to Clause 3,
wherein
the control circuit performs controls to execute the first operation, the first operation including supplying a voltage (VCHPCH) equal to the second voltage to the word line, supplying a voltage (VSGPCH) equal to or greater than the second voltage and equal to or less than the third voltage to the drain side select gate line, and supplying the first voltage to the source side select gate line.

Clause 5. The semiconductor memory device according to Clause 4,
wherein
the control circuit performs controls to execute the second operation, the second operation including, after the first operation, supplying the first voltage to the word line, the drain side select gate line, and the source side select gate line, supplying a voltage (VSG) greater than the first voltage and less than the second voltage to the drain side select gate line after supplying the first voltage, supplying a fourth voltage (VPASS) greater than the third voltage to the word line after supplying the first voltage, boosting a voltage supplied to the third channel to a fifth voltage (VCHB) greater than the second voltage, and boosting a voltage supplied to the first channel to a sixth voltage (VCHC) greater than the third voltage, and
the sixth voltage is greater than the fifth voltage.

Clause 6. The semiconductor memory device according to Clause 5,
wherein
the control circuit performs controls to execute the second operation, the second operation including supplying a seventh voltage (VPGM) greater than the fifth and sixth voltages after supplying the fourth voltage to the word line, maintaining the voltage supplied to the third channel at the fourth voltage, maintaining the voltage supplied to the first channel at the fifth voltage, maintaining the voltage supplied to the second channel at the first voltage, and writing a threshold voltage of any one of the 2ⁿ or more different levels to one second memory cell transistor.

Clause 7. The semiconductor memory device according to Clause 6, further comprising a sense amplifier part (SAU) connected to each of the first bit line, the second bit line, and the third bit line, each including a plurality of latch circuits (SDL, ADL, BDL, CDL, XDL) and a transistor (122) connected to a control signal line (BLC), and capable of generating and storing the 2ⁿ or more different levels of threshold voltages by performing an arithmetic operation using the plurality of latch circuits,
wherein
the control circuit controls the sense amplifier part connected to the second bit line to execute the second operation including supplying the threshold voltage of any one of the different levels to the second bit line and the second memory cell transistor.

Clause 8. The semiconductor memory device according to Clause 7,
wherein
the control circuit performs controls to execute the second operation, the second operation including supplying an eighth voltage (VDD+VTH) greater than the second voltage to the control signal, turning on the transistor, and then supplying a threshold voltage of any one of the different levels to the second bit line and the second memory cell transistor.

Clause 9. The semiconductor memory device according to Clause 8,
wherein
the control circuit supplies the eighth voltage after supplying a ninth voltage (VBLDR) greater than the eighth voltage to the control signal.

Clause 10. The semiconductor memory device according to Clause 7,
wherein
the control circuit performs controls to execute the second operation, the second operation including adjusting a timing of supplying the second voltage to the third channel in accordance with the 2ⁿ or more different levels of threshold voltages generated by the sense amplifier part.

While certain embodiments have been described above, these embodiments have been presented by way of example only, and are not intended to limit the scope of the disclosures. These novel embodiments may be implemented in various other forms and may be implemented in appropriate combinations without departing from the scope of the disclosure, and various omissions, substitutions, and modification may be made. These embodiments and modifications thereof are included in the scope of the disclosure. The accompanying claims are intended to cover forms or modifications as would fall within the scope of the disclosure.

## Claims

1. A non-volatile semiconductor memory device comprising:
a plurality of first memory cell transistors (Mcb1(BLk)), a plurality of second memory cell transistors (Mcb1(BLk-1)), and a plurality of third memory cell transistors (Mcb1(BLk)+1), each of which can be set to a threshold voltage of 2ⁿ (n is an integer equal to or greater than 2) or more different levels;
a first bit line (BLk) extending in a first direction (X direction);
a second bit line (BLk-1) and a third bit line parallel to the first bit line (BLk+1);
a source line (SL1)arranged on a side opposite to the first bit line with respect to the first direction and extending along with a second direction (Y direction) intersecting the first direction;
a first semiconductor layer (Channel(k)) extending in the first direction and including the plurality of first memory cell transistors electrically connected between the first bit line and the source line;
a second semiconductor layer (Channel(k-1)) including the plurality of second memory cell transistors connected between the second bit line and the source line and stacked with the first semiconductor layer along a third direction intersecting both the first direction and the second direction;
a third semiconductor layer (Channel(k+1)) including the plurality of third memory cell transistors connected between the third bit line and the source line and stacked on a side of the first semiconductor layer opposite to a side on which the second semiconductor layer is stacked along the third direction; and
a control circuit (15) configured to control each of the plurality of the first memory cell transistors, each of the plurality of the second memory cell transistors, and each of the plurality of the third memory cell transistors to execute a write operation including a first operation and a second operation,
wherein
when performing the write operation for writing data to one second memory cell transistor among the plurality of the second memory cell transistors, the control circuit performs controls so that it is possible to perform the first operation of supplying a first voltage (VSS) as a reference voltage to the second bit line and a second channel of the plurality of the second memory cell transistors, supplying a second voltage (VDD) greater than the first voltage to the first bit line and a first channel of the plurality of the first memory cell transistors, and then supplying the second voltage to the third bit line and a third channel of the plurality of the third memory cell transistors, and boosting the voltage supplied to the first channel to a third voltage (VDD+dV) greater than the second voltage.

2. The non-volatile semiconductor memory device according to claim 1, further comprising a word line (WLb1) parallel to the source line along the second direction;
wherein
the word line is connected to one second memory cell transistor, one first memory cell transistor among the plurality of first memory cell transistors, and one third memory cell transistor among the plurality of third memory cell transistors, and one first memory cell transistor is programmed with a threshold voltage of the lowest level ("Er" level) among the 2ⁿ or more different levels.

3. The non-volatile semiconductor memory device according to claim 1 or 2, further comprising:
a drain side select gate line (SGD) intersecting the first bit line, the second bit line, and the third bit line;
a source side select gate line (SGS) parallel to the source line;
a first drain side select transistor (ST1-K-1) electrically connected between the first bit line and the plurality of first memory cell transistors;
a first source side select transistor (ST2-K-1) electrically connected between the plurality of first memory cell transistors and the source line;
a second drain side select transistor (ST1-K) electrically connected between the second bit line and the plurality of second memory cell transistors;
a second source side select transistor (ST2-K) electrically connected between the plurality of second memory cell transistors and the source line;
a third drain side select transistor (ST1-K+1) electrically connected between the third bit line and the plurality of third memory cell transistors; and
a third source side select transistor (ST2-K+1) electrically connected between the plurality of third memory cell transistors and the source line;
wherein
the drain side select gate line is connected to the first drain side select transistor, the second drain side select transistor, and the third drain side select transistor, and
the source side select gate line is connected to the first source side select transistor, the second source side select transistor, and the third source side select transistor.

4. The semiconductor memory device according to claim 3, when dependent on claim 2, wherein
the control circuit performs controls to execute the first operation, the first operation including supplying a voltage (VCHPCH) equal to the second voltage to the word line, supplying a voltage (VSGPCH) equal to or greater than the second voltage and equal to or less than the third voltage to the drain side select gate line, and supplying the first voltage to the source side select gate line.

5. The semiconductor memory device according to claim 4,
wherein
the control circuit performs controls to execute the second operation, the second operation including, after the first operation, supplying the first voltage to the word line, the drain side select gate line, and the source side select gate line, supplying a voltage (VSG) greater than the first voltage and less than the second voltage to the drain side select gate line after supplying the first voltage, supplying a fourth voltage (VPASS) greater than the third voltage to the word line after supplying the first voltage, boosting a voltage supplied to the third channel to a fifth voltage (VCHB) greater than the second voltage, and boosting a voltage supplied to the first channel to a sixth voltage (VCHC) greater than the third voltage, and
the sixth voltage is greater than the fifth voltage.

6. The semiconductor memory device according to claim 5,
wherein
the control circuit performs controls to execute the second operation, the second operation including supplying a seventh voltage (VPGM) greater than the fifth and sixth voltages after supplying the fourth voltage to the word line, maintaining the voltage supplied to the third channel at the fourth voltage, maintaining the voltage supplied to the first channel at the fifth voltage, maintaining the voltage supplied to the second channel at the first voltage, and writing a threshold voltage of any one of the 2ⁿ or more different levels to one second memory cell transistor.

7. The semiconductor memory device according to claim 6, further comprising a sense amplifier part (SAU) connected to each of the first bit line, the second bit line, and the third bit line, each including a plurality of latch circuits (SDL, ADL, BDL, CDL, XDL) and a transistor (122) connected to a control signal line (BLC), and capable of generating and storing the 2ⁿ or more different levels of threshold voltages by performing an arithmetic operation using the plurality of latch circuits,
wherein
the control circuit controls the sense amplifier part connected to the second bit line to execute the second operation including supplying the threshold voltage of any one of the different levels to the second bit line and the second memory cell transistor.

8. The semiconductor memory device according to claim 7,
wherein
the control circuit performs controls to execute the second operation, the second operation including supplying an eighth voltage (VDD+VTH) greater than the second voltage to the control signal, turning on the transistor, and then supplying a threshold voltage of any one of the different levels to the second bit line and the second memory cell transistor.

9. The semiconductor memory device according to claim 8,
wherein
the control circuit supplies the eighth voltage after supplying a ninth voltage (VBLDR) greater than the eighth voltage to the control signal.

10. The semiconductor memory device according to any one of claims 7 to 9,
wherein
the control circuit performs controls to execute the second operation, the second operation including adjusting a timing of supplying the second voltage to the third channel in accordance with the 2ⁿ or more different levels of threshold voltages generated by the sense amplifier part.
